# EUROPEAN PATENT APPLICATION

(11) **EP 4 456 701 A1**
(43) Date of publication of application: **30.10.2024**
(21) Application number: 24166013.3
(22) Date of filing: 25.03.2024
(51) Int. Cl.: H10K 85/60, H10K 50/17

(54) **LIGHT EMITTING ELEMENT AND DISPLAY DEVICE INCLUDING THE SAME**

(30) Priority: 20.04.2023 KR 20230052100
(71) Applicant: Samsung Display Co., Ltd., Gyeonggi-Do (KR)
(72) Inventor: BAE, Sung-Soo, Yongin-si (KR); NAIJO, Tsuyoshi, Yongin-si (KR); KIM, Sang Gyun, Yongin-si (KR); SYN, Hojung, Yongin-si (KR); SHIN, Hyosup, Yongin-si (KR); LEE, Jiyoung, Yongin-si (KR); CHU, Changwoong, Yongin-si (KR)
(74) Representative: Marks & Clerk LLP

(57) **Abstract**

A light emitting element includes a first electrode, a hole transport region on the first electrode, an emission layer on the hole transport region, an electron transport region on the emission layer, and a second electrode on the electron transport region. The electron transport region includes an electron transport layer on the emission layer, a first electron injection layer on the electron transport layer, and a second electron injection layer on the first electron injection layer, the thicknesses of the first and second electron injection layers are each about 1 nm to about 5 nm, the first electron injection layer includes a phenanthroline derivative and/or a phosphine oxide derivative, and the second electron injection layer includes a metal material.

## Description

### BACKGROUND

### 1. Field

One or more embodiments of the present disclosure relate to a light emitting element and a display device including the light emitting element, and, for example, to a light emitting element having improved emission efficiency and/or element lifetime and a display device including the light emitting element.

### 2. Description of the Related Art

Recently, the development of an organic electroluminescence display as an image display is being actively conducted. The organic electroluminescence display is different from a liquid crystal display and is a display device of a self-luminescent type or kind in which holes and electrons respectively injected from a first electrode and a second electrode recombine in an emission layer of the organic electroluminescence display so that a light emitting material in the emission layer emits light to achieve a display (e.g., of an image).

In the application of a light emitting element to a display device, a relatively high emission efficiency and relatively long lifetime are required and/or desired, and thus development on materials, for a light emitting element, stably achieving the requirements is being consistently required and/or conducted.

For example, in order to accomplish high efficiency and long lifetime, development on materials of an electron transport region having excellent or suitable electron transport properties and stability is being conducted and/or pursued.

### SUMMARY

One or more aspects of the present disclosure are directed toward a light emitting element having improved emission efficiency and element lifetime.

One or more aspects of the present disclosure are directed toward a display device including a light emitting element having improved emission efficiency and element lifetime.

Additional aspects will be set forth in part in the description which follows and, in part, will be apparent from the description, or may be learned by practice of the presented embodiments.

According to one or more embodiments of the present disclosure, a light emitting element includes a first electrode, a hole transport region on the first electrode, an emission layer on the hole transport region, an electron transport region on the emission layer, and a second electrode on the electron transport region, wherein the electron transport region includes an electron transport layer on the emission layer, a first electron injection layer on the electron transport layer, and a second electron injection layer on the first electron injection layer, a thickness of the first electron injection layer and a thickness of the second electron injection layer each are about 1 nm to about 5 nm, and the first electron injection layer includes at least one of a first compound represented by Formula 1 or a second compound represented by Formula 2, and the second electron injection layer includes a metal material.

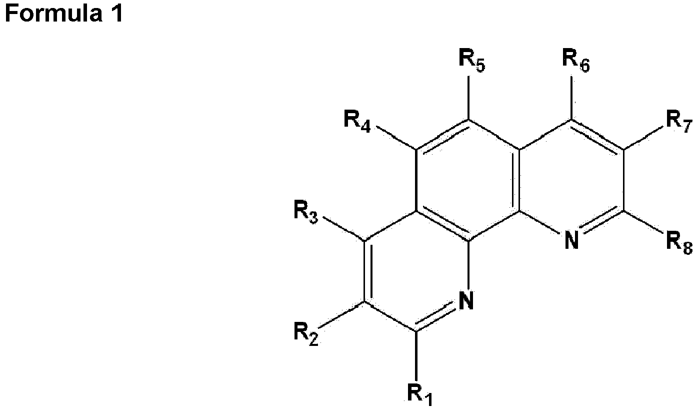

In Formula 1, R₁ to R₈ are each independently hydrogen, deuterium, a halogen, a cyano group, a hydroxyl group, a substituted or unsubstituted oxy group, a substituted or unsubstituted thio group, a substituted or unsubstituted amine group, a substituted or unsubstituted alkyl group of 1 to 20 carbon atoms, a substituted or unsubstituted alkenyl group of 2 to 20 carbon atoms, a substituted or unsubstituted aryl group of 6 to 30 ring-forming carbon atoms, or a substituted or unsubstituted heteroaryl group of 2 to 30 ring-forming carbon atoms.

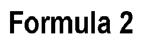

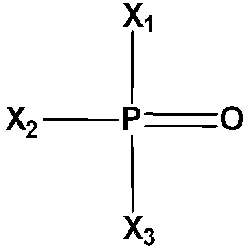

In Formula 2, X₁ to X₃ are each independently hydrogen, deuterium, a substituted or unsubstituted alkyl group of 1 to 20 carbon atoms, a substituted or unsubstituted alkenyl group of 2 to 20 carbon atoms, a substituted or unsubstituted aryl group of 6 to 30 ring-forming carbon atoms, or a substituted or unsubstituted heteroaryl group of 2 to 30 ring-forming carbon atoms, and/or combined with an adjacent group to form a ring.

In one or more embodiments, the first electron injection layer may not include (e.g., may exclude) a metal material (e.g., any metal material).

In one or more embodiments, the second electron injection layer may be directly on the first electron injection layer.

In one or more embodiments, at least a portion of the metal material of the second electron injection layer may make a coordinate covalent bond with the N atom of the first compound represented by Formula 1 or the O atom of the second compound represented by Formula 2.

In one or more embodiments, the first electron injection layer may be composed of (e.g., may consist (essentially) of) the first compound represented by Formula 1 and/or the second compound represented by Formula 2.

In one or more embodiments, an energy level of a lowest unoccupied molecular orbital (LUMO) of the first electron injection layer may be about -1.85 eV or less, and an energy level of a highest occupied molecular orbital (HOMO) of the first electron injection layer may be about -5.60 eV or less.

In one or more embodiments, in Formula 1, R₁ to R₃, and R₆ to R₈ may each independently be hydrogen, deuterium, a substituted or unsubstituted oxy group, a substituted or unsubstituted amine group, a substituted or unsubstituted aryl group of 6 to 30 ring-forming carbon atoms, or a substituted or unsubstituted heteroaryl group of 2 to 30 ring-forming carbon atoms.

In one or more embodiments, in Formula 2, X₁ to X₃ may each independently be a substituted or unsubstituted aryl group of 6 to 30 ring-forming carbon atoms, or a substituted or unsubstituted heteroaryl group of 2 to 30 ring-forming carbon atoms, and/or combined with an adjacent group to form a ring.

In one or more embodiments, a sum of the thickness of the first electron injection layer and the thickness of the second electron injection layer may be about 2 nm to about 4 nm.

In one or more embodiments, a thickness percent of the first electron injection layer or a thickness percent of the second electron injection layer with respect to a thickness of the electron transport layer may be from about 3% to about 7%.

In one or more embodiments, the second electron injection layer may include a metal of lanthanoids (e.g., a lanthanide metal).

In one or more embodiments, the electron transport layer may include a metal material.

In one or more embodiments, the electron transport region may further include a hole blocking layer between the electron transport layer and the emission layer.

In one or more embodiments, the second electrode may be directly on the second electron injection layer.

According to one or more embodiments of the present disclosure, a light emitting element includes a first electrode, a hole injection layer on the first electrode, a hole transport layer on the hole injection layer, an emission layer on the hole transport layer, an electron transport layer on the emission layer, a first electron injection layer on the electron transport layer, a second electron injection layer directly on the first electron injection layer, and a second electrode on the second electron injection layer, wherein a ratio of a thickness of the second electron injection layer to a thickness of the first electron injection layer is from about 1 : 1 to about 5 : 1, the first electron injection layer is composed of (e.g., consisted (essentially) of) a phenanthroline derivative and/or a phosphine oxide derivative, and the second electron injection layer includes a metal material.

According to one or more embodiments of the present disclosure, a display device includes a base layer including multiple luminous areas and multiple nonluminous areas adjacent to the multiple luminous areas, and multiple light emitting elements on the base layer and corresponding to the multiple luminous areas, respectively, wherein at least a portion of the multiple light emitting elements includes a first electrode, a hole transport region on the first electrode, an emission layer on the hole transport region, an electron transport region on the emission layer, and a second electrode on the electron transport region, the electron transport region includes an electron transport layer on the emission layer, a first electron injection layer on the electron transport layer, and a second electron injection layer on the first electron injection layer, a thickness of the first electron injection layer and a thickness of the second electron injection layer each are about 1 nm to about 5 nm, and the first electron injection layer includes at least one of a first compound represented by Formula 1 or a second compound represented by Formula 2, where the second electron injection layer includes a metal material.

In one or more embodiments, the multiple luminous areas may include a red luminous area to radiate red light, a green luminous area to radiate green light, and a blue luminous area to radiate blue light, the multiple light emitting elements may include a first light emitting element to emit red light, a second light emitting element to emit green light, and a third light emitting element to emit blue light, and the first light emitting element may correspond to the red luminous area, the second light emitting element may correspond to the green luminous area, and the third light emitting element may correspond to the blue luminous area.

At least some of the above and other features of the invention are set out in the claims.

### BRIEF DESCRIPTION OF THE DRAWINGS

The accompanying drawings are included to provide a further understanding of the present disclosure and are incorporated in and constitute a part of the present disclosure. The drawings illustrate embodiments of the present disclosure and, together with the description, serve to explain principles of the present disclosure. Above and/or other aspects of the present disclosure should become apparent and appreciated from the following description of embodiments taken in conjunction with the accompanying drawings. In the drawings:
FIG. 1 is a plan view of a display device according to one or more embodiments of the present disclosure;
FIG. 2 is a cross-sectional view of a display device according to one or more embodiments of the present disclosure;
FIG. 3 is a cross-sectional view schematically showing a light emitting element according to one or more embodiments of the present disclosure;
FIG. 4 is a cross-sectional view schematically showing a light emitting element according to one or more embodiments of the present disclosure;
FIG. 5 is a cross-sectional view schematically showing a light emitting element according to one or more embodiments of the present disclosure;
FIG. 6 is a cross-sectional view schematically showing a light emitting element according to one or more embodiments of the present disclosure;
FIG. 7 and FIG. 8 are each a cross-sectional view of a display device according to one or more embodiments of the present disclosure;
FIG. 9 is a cross-sectional view showing a display device according to one or more embodiments of the present disclosure;
FIG. 10 is a cross-sectional view showing a display device according to one or more embodiments of the present disclosure;
FIG. 11 is a diagram showing a vehicle provided with a display device according to one or more embodiments of the present disclosure;
FIG. 12A and FIG. 12B are each an enlarged photographic image of a portion of a plane of (e.g., a plan view of) a luminous area of a light emitting element according to one or more embodiments of the present disclosure; and
FIG. 12C is an enlarged photographic image of a portion of a plane of (e.g., a plan view of) a luminous area of a light emitting element according to a Comparative Example of the present disclosure.

### DETAILED DESCRIPTION

The present disclosure may be modified in one or more suitable manners and have many forms, and thus specific embodiments will be exemplified in the drawings and described in more detail in the detailed description of the present disclosure. It should be understood, however, that it is not intended to limit the present disclosure to the particular forms disclosed, but rather, is intended to cover all modifications, equivalents, and alternatives falling within the scope of the present disclosure.

When explaining each of the drawings, like reference numbers are utilized for referring to like elements. In the accompanying drawings, the dimensions of each structure may be exaggeratingly illustrated for clarity of the present disclosure. It will be understood that, although the terms "first," "second," *etc.,* may be utilized herein to describe one or more suitable components, these components should not be limited by these terms. These terms are only utilized to distinguish one component from another. For example, a first component could be termed a second component, and, similarly, a second component could be termed a first component, without departing from the scope of example embodiments of the present disclosure. As utilized herein, the singular forms, "a," "an," and "the" are intended to include the plural forms as well, unless the context clearly indicates otherwise. Further, the utilization of "may" when describing embodiments of the present disclosure refers to "one or more embodiments of the present disclosure".

In the present disclosure, it will be understood that the terms "comprise(s), "include(s)," "have/has," and/or the like specify the presence of features, numbers, steps, operations, component, parts, or combinations thereof disclosed in the disclosure, but do not exclude the possibility of presence or addition of one or more other features, numbers, steps, operations, component, parts, or combinations thereof. As utilized herein, the terms "and," "or," and "and/or" may include any and all combinations of one or more of the associated listed items. Expressions such as "at least one of," "one of," and "selected from," when preceding a list of elements, modify the entire list of elements and do not modify the individual elements of the list. For example, "at least one of a, b, or c", "at least one selected from a, b, and c", "at least one selected from among a to c", *etc.,* may indicate only a, only b, only c, both (*e.g.,* simultaneously) a and b, both (*e.g.,* simultaneously) a and c, both (*e.g.,* simultaneously) b and c, all of a, b, and c, or variations thereof. The *"*/*"* utilized herein may be interpreted as "and" or as "or" depending on the situation.

In the present disclosure, when a layer, a film, a region, or a plate is referred to as being "on" or "in an upper portion of" another layer, film, region, or plate, it may be not only "directly on" the layer, film, region, or plate, but one or more intervening layers, films, regions, or plates may also be present. Opposite this, when a layer, a film, a region, or a plate is referred to as being "below", "in a lower portion of" another layer, film, region, or plate, it can be not only directly under the layer, film, region, or plate, but one or more intervening layers, films, regions, or plates may also be present. In some embodiments, it will be understood that when a part is referred to as being "on" another part, it can be disposed above the other part, or disposed under the other part as well. In the present disclosure, "directly on" may refer to that there are no additional layers, films, regions, plates, *etc.,* between a layer, a film, a region, a plate, *etc.* and the other part. For example, "directly on" may refer to two layers or two members that are disposed without utilizing an additional member therebetween.

In the present disclosure, the term "substituted or unsubstituted" may refer to substituted or unsubstituted with at least one substituent selected from the group consisting of deuterium, a halogen, a cyano group, a nitro group, an amino group, a silyl group, an oxy group, a thio group, a sulfinyl group, a sulfonyl group, a carbonyl group, a boron group, a phosphine oxide group, a phosphine sulfide group, an alkyl group, an alkenyl group, an alkynyl group, a hydrocarbon ring group, an aryl group, and a heterocyclic group. In some embodiments, each of the substituents exemplified above may be substituted or unsubstituted. For example, a biphenyl group may be interpreted as an aryl group or a phenyl group substituted with a phenyl group.

In the present disclosure, the phrase "bonded to an adjacent group to form a ring" may refer to that a group is bonded to an adjacent group to form a substituted or unsubstituted hydrocarbon ring, or a substituted or unsubstituted heterocycle. The hydrocarbon ring may include an aliphatic hydrocarbon ring and/or an aromatic hydrocarbon ring. The heterocycle may include an aliphatic heterocycle and/or an aromatic heterocycle. The hydrocarbon ring and the heterocycle may each be monocyclic or polycyclic. In some embodiments, the rings formed by two adjacent groups being bonded to each other may be connected to another ring to form a spiro structure.

In the present disclosure, the term "adjacent group" may refer to a substituent substituted for an atom which is directly linked to an atom substituted with a corresponding substituent, another substituent substituted for an atom which is substituted with a corresponding substituent, or a substituent sterically positioned at the nearest position to a corresponding substituent. For example, two methyl groups in 1 ,2-dimethylbenzene may be interpreted as "adjacent groups" to each other and two ethyl groups in 1,1-diethylcyclopentane may be interpreted as "adjacent groups" to each other. In some embodiments, two methyl groups in 4,5-dimethylphenanthrene may be interpreted as "adjacent groups" to each other.

In the present disclosure, examples of the halogen may include fluorine, chlorine, bromine, or iodine.

In the present disclosure, an alkyl group may be linear or branched. The number of carbons in the alkyl group may be 1 to 50, 1 to 30, 1 to 20, 1 to 10, or 1 to 6. Examples of the alkyl group may include a methyl group, an ethyl group, an n-propyl group, an isopropyl group, an n-butyl group, an s-butyl group, a t-butyl group, an i-butyl group, a 2-ethylbutyl group, a 3,3-dimethylbutyl group, an n-pentyl group, an i-pentyl group, a neopentyl group, a t-pentyl group, a 1-methylpentyl group, a 3-methylpentyl group, a 2-ethylpentyl group, a 4-methyl-2-pentyl group, an n-hexyl group, a 1-methylhexyl group, a 2-ethylhexyl group, a 2-butylhexyl group, an n-heptyl group, a 1-methylheptyl group, a 2,2-dimethylheptyl group, a 2-ethylheptyl group, a 2-butylheptyl group, an n-octyl group, a t-octyl group, a 2-ethyloctyl group, a 2-butyloctyl group, a 2-hexyloctyl group, a 3,7-dimethyloctyl group, an n-nonyl group, an n-decyl group, an adamantyl group, a 2-ethyldecyl group, a 2-butyldecyl group, a 2-hexyldecyl group, a 2-octyldecyl group, an n-undecyl group, an n-dodecyl group, a 2-ethyldodecyl group, a 2-butyldodecyl group, a 2-hexyldocecyl group, a 2-octyldodecyl group, an n-tridecyl group, an n-tetradecyl group, an n-pentadecyl group, an n-hexadecyl group, a 2-ethylhexadecyl group, a 2-butylhexadecyl group, a 2-hexylhexadecyl group, a 2-octylhexadecyl group, an n-heptadecyl group, an n-octadecyl group, an n-nonadecyl group, an n-eicosyl group, a 2-ethyleicosyl group, a 2-butyleicosyl group, a 2-hexyleicosyl group, a 2-octyleicosyl group, an n-henicosyl group, an n-docosyl group, an n-tricosyl group, an n-tetracosyl group, an n-pentacosyl group, an n-hexacosyl group, an n-heptacosyl group, an n-octacosyl group, an n-nonacosyl group, an n-triacontyl group, *etc.,* but embodiments of the present disclosure are not limited thereto.

In the present disclosure, a cycloalkyl group may refer to a cyclic alkyl group. The number of carbons in the cycloalkyl group may be 3 to 50, 3 to 30, 3 to 20, or 3 to 10. Examples of the cycloalkyl group may include a cyclopropyl group, a cyclobutyl group, a cyclopentyl group, a cyclohexyl group, a 4-methylcyclohexyl group, a 4-t-butylcyclohexyl group, a cycloheptyl group, a cyclooctyl group, a cyclononyl group, a cyclodecyl group, a norbornyl group, a 1-adamantyl group, a 2-adamantyl group, an isobornyl group, a bicycloheptyl group, *etc.,* but embodiments of the present disclosure are not limited thereto.

In the present disclosure, an alkenyl group may refer to a hydrocarbon group including at least one carbon-carbon double bond in the middle or terminal of an alkyl group having 2 or more carbon atoms. The alkenyl group may be linear or branched. The number of carbon atoms in the alkenyl group is not specifically limited, for example, may be 2 to 30, 2 to 20, or 2 to 10. Examples of the alkenyl group may include a vinyl group, a 1-butenyl group, a 1-pentenyl group, a 1 ,3-butadienyl aryl group, a styrenyl group, a styryl vinyl group, *etc.,* but embodiments of the present disclosure are not limited thereto.

In the present disclosure, an alkynyl group may refer to a hydrocarbon group including at least one carbon-carbon triple bond in the middle or terminal of an alkyl group having 2 or more carbon atoms. The alkynyl group may be linear or branched. Although the number of carbon atoms is not specifically limited, it may be 2 to 30, 2 to 20, or 2 to 10. Examples of the alkynyl group may include an ethynyl group, a propynyl group, *etc.,* but embodiments of the present disclosure are not limited thereto.

In the present disclosure, the hydrocarbon ring group may refer to any functional group or substituent derived from an aliphatic hydrocarbon ring. The hydrocarbon ring group may be a saturated hydrocarbon ring group having 5 to 20 ring-forming carbon atoms.

In the present disclosure, an aryl group may refer to any functional group or substituent derived from an aromatic hydrocarbon ring. The aryl group may be a monocyclic aryl group or a polycyclic aryl group. The number of ring-forming carbon atoms in the aryl group may be 6 to 36, 6 to 30, 6 to 20, or 6 to 15. Examples of the aryl group may include a phenyl group, a naphthyl group, a fluorenyl group, an anthracenyl group, a phenanthryl group, a biphenyl group, a terphenyl group, a quaterphenyl group, a quinquephenyl group, a sexiphenyl group, a triphenylenyl group, a pyrenyl group, a benzofluoranthenyl group, a chrysenyl group, *etc.,* but embodiments of the present disclosure are not limited thereto.

In the present disclosure, the fluorenyl group may be substituted, and two substituents may be bonded to each other to form a spiro structure. Examples of the substituted fluorenyl group are as follows. However, embodiments of the present disclosure are not limited thereto.

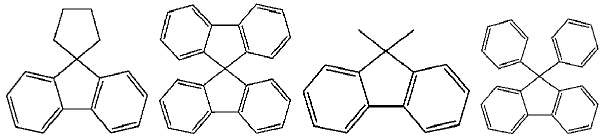

A heterocyclic group utilized herein may refer to any functional group or substituent derived from a ring containing at least one of B, O, N, P, Si, or Se as a heteroatom. The heterocyclic group may include an aliphatic heterocyclic group and/or an aromatic heterocyclic group. The aromatic heterocyclic group may be a heteroaryl group. The aliphatic heterocycle and the aromatic heterocycle may each be monocyclic or polycyclic.

In the present disclosure, the heterocyclic group may contain at least one of B, O, N, P, Si, or S as a heteroatom. When the heterocyclic group contains two or more heteroatoms, the two or more heteroatoms may be the same as or different from each other. The heterocyclic group may be a monocyclic heterocyclic group or a polycyclic heterocyclic group, and may include a heteroaryl group. The number of ring-forming carbon atoms in the heterocyclic group may be 2 to 30, 2 to 20, or 2 to 10.

In the present disclosure, the aliphatic heterocyclic group may include at least one of B, O, N, P, Si, or S as a heteroatom. The number of ring-forming carbon atoms in the aliphatic heterocyclic group may be 2 to 30, 2 to 20, or 2 to 10. Examples of the aliphatic heterocyclic group may include an oxirane group, a thiirane group, a pyrrolidine group, a piperidine group, a tetrahydrofuran group, a tetrahydrothiophene group, a thiane group, a tetrahydropyran group, a 1,4-dioxane group, *etc.,* but embodiments of the present disclosure are not limited thereto.

In the present disclosure, the heteroaryl group may contain at least one of B, O, N, P, Si, or S as a heteroatom. When the heteroaryl group contains two or more heteroatoms, the two or more heteroatoms may be the same as or different from each other. The heteroaryl group may be a monocyclic heterocyclic group or a polycyclic heterocyclic group. The number of ring-forming carbon atoms in the heteroaryl group may be 2 to 30, 2 to 20, or 2 to 10. Examples of the heteroaryl group may include a thiophene group, a furan group, a pyrrole group, an imidazole group, a pyridine group, a bipyridine group, a pyrimidine group, a triazine group, a triazole group, an acridyl group, a pyridazine group, a pyrazinyl group, a quinoline group, a quinazoline group, a quinoxaline group, a phenoxazine group, a phthalazine group, a pyrido pyrimidine group, a pyrido pyrazine group, a pyrazino pyrazine group, an isoquinoline group, an indole group, a carbazole group, an N-arylcarbazole group, an N-heteroarylcarbazole group, an N-alkylcarbazole group, a benzoxazole group, a benzimidazole group, a benzothiazole group, a benzocarbazole group, a benzothiophene group, a dibenzothiophene group, a thienothiophene group, a benzofuran group, a phenanthroline group, a thiazole group, an isoxazole group, an oxazole group, an oxadiazole group, a thiadiazole group, a phenothiazine group, a dibenzosilole group, a dibenzofuran group, *etc.,* but embodiments of the present disclosure are not limited thereto.

In the present disclosure, the above description of the aryl group may be applied to an arylene group except that the arylene group is a divalent group. The above description of the heteroaryl group may be applied to a heteroarylene group except that the heteroarylene group is a divalent group.

In the present disclosure, the silyl group may include an alkylsilyl group and/or an arylsilyl group. Examples of the silyl group may include a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group, *etc.,* but embodiments of the present disclosure are not limited thereto.

In the present disclosure, the number of ring-forming carbon atoms in a carbonyl group is not specifically limited, for example, may be 1 to 40, 1 to 30, or 1 to 20. For example, the carbonyl group may have the following structures, but embodiments of the present disclosure are not limited thereto.

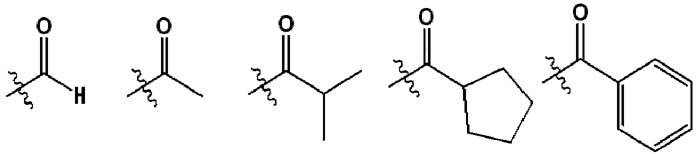

In the present disclosure, the number of carbon atoms in a sulfinyl group or a sulfonyl group is not particularly limited, for example, may be 1 to 30. The sulfinyl group may include an alkyl sulfinyl group and/or an aryl sulfinyl group. The sulfonyl group may include an alkyl sulfonyl group and/or an aryl sulfonyl group.

In the present disclosure, a thio group may include an alkylthio group and/or an arylthio group. The thio group may refer to that a sulfur atom is bonded to the alkyl group or the aryl group as defined above. Examples of the thio group may include a methylthio group, an ethylthio group, a propylthio group, a pentylthio group, a hexylthio group, an octylthio group, a dodecylthio group, a cyclopentylthio group, a cyclohexylthio group, a phenylthio group, a naphthylthio group, but embodiments of the present disclosure are not limited thereto.

In the present disclosure, an oxy group may refer to that an oxygen atom is bonded to the alkyl group or the aryl group as defined above. The oxy group may include an alkoxy group and/or an aryl oxy group. The alkoxy group may be a linear chain, a branched chain, or a ring. The number of carbon atoms in the alkoxy group is not specifically limited, but may be, for example, 1 to 20 or 1 to 10. Examples of the oxy group may include methoxy, ethoxy, n-propoxy, isopropoxy, butoxy, pentyloxy, hexyloxy, octyloxy, nonyloxy, decyloxy, benzyloxy, *etc.,* but embodiments of the present disclosure are not limited thereto.

A boron group as utilized herein may refer to that a boron atom is bonded to the alkyl group or the aryl group as defined above. The boron group may include an alkyl boron group and/or an aryl boron group. Examples of the boron group may include a dimethylboron group, a trimethylboron group, a t-butyldimethylboron group, a diphenylboron group, a phenylboron group, *etc.,* but embodiments of the present disclosure are not limited thereto.

In the present disclosure, an alkenyl group may be linear or branched. The number of carbon atoms in the alkenyl group is not specifically limited, but is 2 to 30, 2 to 20, or 2 to 10. Examples of the alkenyl group may include a vinyl group, a 1-butenyl group, a 1-pentenyl group, a 1,3-butadienyl aryl group, a styrenyl group, a styryl vinyl group, *etc.,* but embodiments of the present disclosure are not limited thereto.

In the present disclosure, the number of carbon atoms in an amine group is not specifically limited, for example, may be 1 to 30. The amine group may include an alkyl amine group and/or an aryl amine group. Examples of the amine group may include a methylamine group, a dimethylamine group, a phenylamine group, a diphenylamine group, a naphthylamine group, a 9-methyl-anthracenylamine group, a triphenylamine group, *etc.,* but embodiments of the present disclosure are not limited thereto.

In the present disclosure, the alkyl group among an alkoxy group, an alkylthio group, an alkylsulfoxy group, an alkylaryl group, an alkylamino group, an alkyl boron group, an alkyl silyl group, and an alkyl amine group may be the same as the examples of the alkyl group described above.

In the present disclosure, the aryl group among an aryloxy group, an arylthio group, an arylsulfoxy group, an arylamino group, an arylboron group, an arylsilyl group, and an arylamine group may be the same as the examples of the aryl group described above.

In the present disclosure, a direct linkage may refer to a single bond.

In the present disclosure, 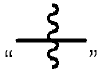 and 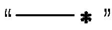 may refer to a position to be connected.

Hereinafter, embodiments of the present disclosure will be described with reference to the accompanying drawings. In the present disclosure, term "light emitting device" may be utilized interchangeably with the term "light emitting element."

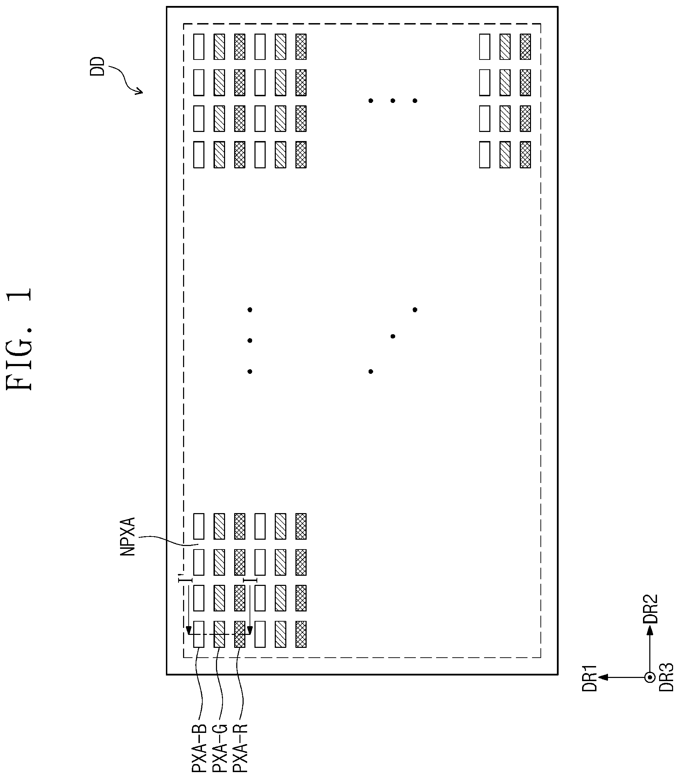

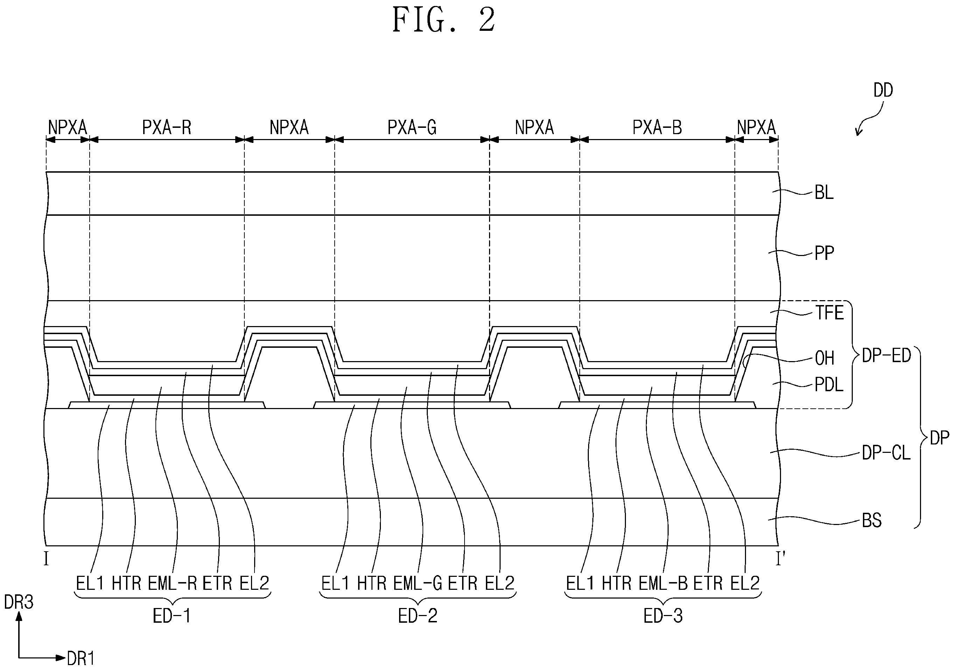

FIG. 1 is a plan view illustrating a display apparatus DD according to one or more embodiments of the present disclosure. FIG. 2 is a cross-sectional view of the display apparatus DD according to one or more embodiments of the present disclosure. FIG. 2 is a cross-sectional view illustrating a part taken along line I-I' of FIG. 1.

The display apparatus DD may include a display panel DP and an optical layer PP disposed on the display panel DP. The display panel DP may include light emitting devices ED-1, ED-2, and ED-3. The display apparatus DD may include a plurality of light emitting devices ED-1, ED-2, and ED-3. The optical layer PP may be disposed on the display panel DP to control reflected light in the display panel DP due to external light. The optical layer PP may include, for example, a polarization layer and/or a color filter layer. In some embodiments, the optical layer PP may not be provided in the display apparatus DD.

A base substrate BL may be provided and disposed on the optical layer PP. The base substrate BL may be a member which provides a base surface on which the optical layer PP disposed. The base substrate BL may be a glass substrate, a metal substrate, a plastic substrate, *etc.* However, embodiments of the present disclosure are not limited thereto, and the base substrate BL may be an inorganic layer, an organic layer, or a composite material layer. In some embodiments, the base substrate BL may not be provided.

The display apparatus DD according to one or more embodiments may further include a filling layer. The filling layer may be disposed between a display device layer DP-ED and the base substrate BL. The filling layer may be an organic material layer. The filling layer may include at least one of an acrylic-based resin, a silicone-based resin, or an epoxy-based resin.

The display panel DP may include a base layer BS, a circuit layer DP-CL provided on the base layer BS, and a display device layer DP-ED. The display device layer DP-ED may include a pixel defining film PDL, the light emitting devices ED-1, ED-2, and ED-3 disposed between respective portions of the pixel defining film PDL, and an encapsulation layer TFE disposed on the light emitting devices ED-1, ED-2, and ED-3.

The base layer BS may be a member which provides a base surface on which the display device layer DP-ED is disposed. The base layer BS may be a glass substrate, a metal substrate, a plastic substrate, *etc.* However, embodiments of the present disclosure are not limited thereto, and the base layer BS may be an inorganic layer, an organic layer, or a composite material layer.

In one or more embodiments, the circuit layer DP-CL may be disposed on the base layer BS, and the circuit layer DP-CL may include a plurality of transistors. Each of the transistors may include a control electrode, an input electrode, and an output electrode. For example, in some embodiments, the circuit layer DP-CL may include switching transistor(s) and driving transistor(s) for driving the light emitting devices ED-1, ED-2, and ED-3 of the display device layer DP-ED.

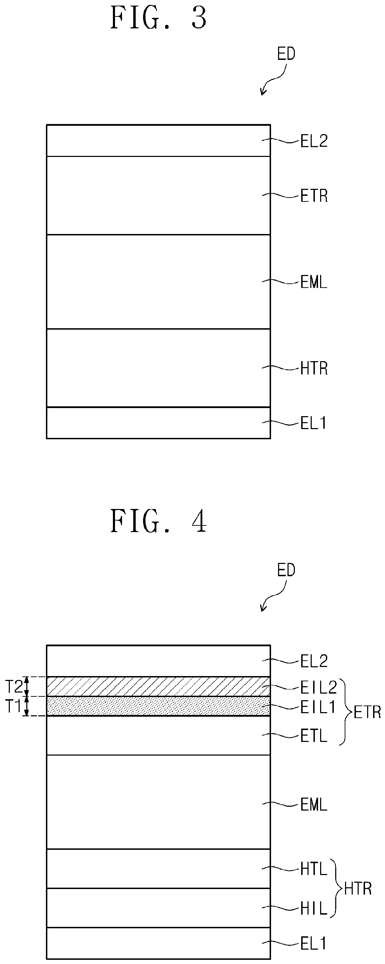

Each of the light emitting devices ED-1, ED-2, and ED-3 may independently have a structure of one of light emitting devices ED of embodiments according to FIGs. 3 to 6, which will be described later. Each of the light emitting devices ED-1, ED-2, and ED-3 may include a first electrode EL1, a hole transport region HTR, respective emission layers EML-R, EML-G, and EML-B, an electron transport region ETR, and a second electrode EL2.

FIG. 2 illustrates an embodiment in which the respective emission layers EML-R, EML-G, and EML-B of the light emitting devices ED-1, ED-2, and ED-3 are disposed in openings OH defined in the pixel defining film PDL, and the hole transport region HTR, the electron transport region ETR, and the second electrode EL2 are provided as a common layer in the entire light emitting devices ED-1, ED-2, and ED-3. However, embodiments of the present disclosure are not limited thereto, and in some embodiments, the hole transport region HTR and the electron transport region ETR may be provided by being patterned inside the openings OH defined in the pixel defining film PDL. For example, in some embodiments, the hole transport region HTR, the respective emission layers EML-R, EML-G, and EML-B, and the electron transport region ETR of the light emitting devices ED-1, ED-2, and ED-3 may be provided by being patterned in an inkjet printing method.

The encapsulation layer TFE may cover the light emitting devices ED-1, ED-2, and ED-3. The encapsulation layer TFE may seal the display device layer DP-ED. The encapsulation layer TFE may be a thin film encapsulation layer. The encapsulation layer TFE may be formed by laminating one layer or a plurality of layers. The encapsulation layer TFE may include at least one insulation layer. In some embodiments, the encapsulation layer TFE may include at least one inorganic film (hereinafter, an encapsulation-inorganic film). In some embodiments, the encapsulation layer TFE may also include at least one organic film (hereinafter, an encapsulation-organic film) and at least one encapsulation-inorganic film.

The encapsulation-inorganic film protects the display device layer DP-ED from moisture/oxygen, and the encapsulation-organic film protects the display device layer DP-ED from foreign substances such as dust particles. The encapsulation-inorganic film may include silicon nitride, silicon oxynitride, silicon oxide, titanium oxide, aluminium oxide, and/or the like, but embodiments of the present disclosure are not particularly limited thereto. The encapsulation-organic film may include an acrylic-based compound, an epoxy-based compound, and/or the like. In some embodiments, the encapsulation-organic film may include a photopolymerizable organic material, but embodiments of the present disclosure are not particularly limited thereto.

The encapsulation layer TFE may be disposed on the second electrode EL2 and may be disposed filling the opening OH.

Referring to FIG. 1 and FIG. 2, the display apparatus DD may include a non-light emitting region NPXA and light emitting regions PXA-R, PXA-G, and PXA-B. The light emitting regions PXA-R, PXA-G, and PXA-B may be regions in which light generated by the respective light emitting devices ED-1, ED-2, and ED-3 is emitted. The light emitting regions PXA-R, PXA-G, and PXA-B may be spaced apart from each other on a plane.

Each of the light emitting regions PXA-R, PXA-G, and PXA-B may be a region divided by the pixel defining film PDL. The non-light emitting areas NPXA may be areas between adjacent light emitting areas PXA-R, PXA-G, and PXA-B, which correspond to the pixel defining film PDL. In some embodiments, the light emitting regions PXA-R, PXA-G, and PXA-B may respectively correspond to pixels. The pixel defining film PDL may divide the light emitting devices ED-1, ED-2, and ED-3. The respective emission layers EML-R, EML-G, and EML-B of the light emitting devices ED-1, ED-2, and ED-3 may be disposed in openings OH defined in the pixel defining film PDL and separated from each other.

The light emitting regions PXA-R, PXA-G, and PXA-B may be divided into a plurality of groups according to the color of light generated from the light emitting devices ED-1, ED-2, and ED-3. In the display apparatus DD of one or more embodiments illustrated in FIG. 1 and FIG. 2, three light emitting regions PXA-R, PXA-G, and PXA-B, which emit red light, green light, and blue light, respectively, are illustrated as an example. For example, in one or more embodiments, the display device DD may include a red light emitting region PXA-R, a green light emitting region PXA-G, and a blue light emitting region PXA-B that are separated from each other.

In the display apparatus DD according to one or more embodiments, the plurality of light emitting devices ED-1, ED-2, and ED-3 may be to emit light beams having wavelengths different from each other. For example, in some embodiments, the display apparatus DD may include a first light emitting device ED-1 that emits red light, a second light emitting device ED-2 that emits green light, and a third light emitting device ED-3 that emits blue light. For example, in some embodiments, the red light emitting region PXA-R, the green light emitting region PXA-G, and the blue light emitting region PXA-B of the display apparatus DD may correspond to the first light emitting device ED-1, the second light emitting device ED-2, and the third light emitting device ED-3, respectively.

However, embodiments of the present disclosure are not limited thereto, and the first to third light emitting devices ED-1, ED-2, and ED-3 may be to emit light beams in substantially the same wavelength range or at least one light emitting device may be to emit a light beam in a wavelength range different from the others. For example, in some embodiments, the first to third light emitting devices ED-1, ED-2, and ED-3 may all emit blue light.

The light emitting regions PXA-R, PXA-G, and PXA-B in the display apparatus DD according to one or more embodiments may be arranged in a stripe form. Referring to FIG. 1, a plurality of red light emitting regions PXA-R may be arranged with each other along a second direction axis DR2, a plurality of green light emitting regions PXA-G may be arranged with each other along the second direction axis DR2, and a plurality of blue light emitting regions PXA-B may be arranged with each other along the second direction axis DR2. In some embodiments, the red light emitting region PXA-R, the green light emitting region PXA-G, and the blue light emitting region PXA-B may be alternately arranged in this order along a first direction axis DR1.

FIG. 1 and FIG. 2 illustrate that all the light emitting regions PXA-R, PXA-G, and PXA-B have similar area, but embodiments of the present disclosure are not limited thereto. Thus, the light emitting regions PXA-R, PXA-G, and PXA-B may have different areas from each other according to the wavelength range of the emitted light. The areas of the light emitting regions PXA-R, PXA-G, and PXA-B may refer to areas when viewed on a plane defined by the first direction axis DR1 and the second direction axis DR2 (*e.g.,* the areas in a plan view).

In some embodiments, an arrangement form of the light emitting regions PXA-R, PXA-G, and PXA-B is not limited to the configuration illustrated in FIG. 1, and the order in which the red light emitting region PXA-R, the green light emitting region PXA-G, and the blue light emitting region PXA-B are arranged may be provided in one or more suitable combinations according to the characteristics of display quality required in the display apparatus DD. For example, in some embodiments, the arrangement form of the light emitting regions PXA-R, PXA-G, and PXA-B may be a pentile (PENTILE^{®}) arrangement form (for example, an RGBG matrix, an RGBG structure, or RGBG matrix structure) or a diamond (Diamond Pixel^{™}) arrangement form (*e.g.,* a display (*e.g.,* an OLED display) containing red, blue, and green (RGB) light-emitting regions arranged in the shape of diamonds). PENTILE^{®} is a duly registered trademark of Samsung Display Co., Ltd. Diamond Pixel^{™} is a trademark of Samsung Display Co., Ltd.

In some embodiments, the areas of the light emitting regions PXA-R, PXA-G, and PXA-B may be different from each other. For example, in some embodiments, the area of the green light emitting region PXA-G may be smaller than that of the blue light emitting region PXA-B, but embodiments of the present disclosure are not limited thereto.

Hereinafter, FIG. 3 to FIG. 6 are each a cross-sectional view schematically showing a light emitting elements according to one or more embodiments of the present disclosure. The light emitting element ED of one or more embodiments includes a first electrode EL1, a hole transport region HTR, an emission layer EML, an electron transport region ETR, and a second electrode EL2 stacked in order (*e.g.,* in the stated order).

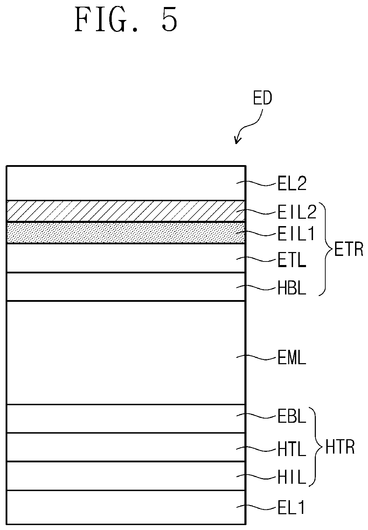

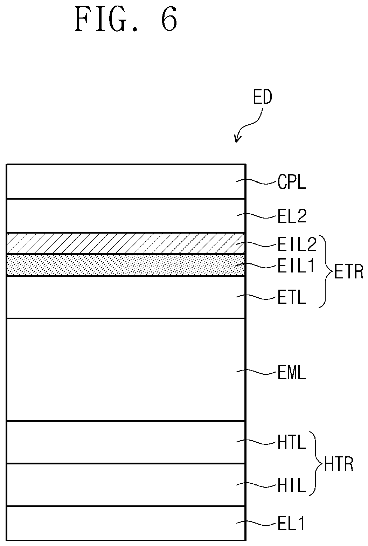

Compared with FIG. 3, FIG. 4 illustrates a cross-sectional view of a light emitting element ED of one or more embodiments, in which a hole transport region HTR may include a hole injection layer HIL and a hole transport layer HTL, and an electron transport region ETR may include a first electron injection layer EIL1, a second electron injection layer EIL2, and an electron transport layer ETL. In some embodiments, compared with FIG. 3, FIG. 5 illustrates a cross-sectional view of a light emitting element ED, in which a hole transport region HTR may include a hole injection layer HIL, a hole transport layer HTL, and an electron blocking layer EBL, and an electron transport region ETR may include a first electron injection layer EIL1, a second electron injection layer EIL2, an electron transport layer ETL, and a hole blocking layer HBL. Compared with FIG. 4, FIG. 6 illustrates a cross-sectional view of a light emitting element ED of one or more embodiments including a capping layer CPL disposed on a second electrode EL2.

The first electrode EL1 has conductivity (*e.g.,* is a conductor). The first electrode EL1 may be formed of a metal material, a metal alloy, or a conductive compound. The first electrode EL1 may be an anode or a cathode. However, embodiments of the present disclosure are not limited thereto. In one or more embodiments, the first electrode EL1 may be a pixel electrode. The first electrode EL1 may be a transmissive electrode, a transflective electrode, or a reflective electrode. The first electrode EL1 may include at least one selected from among silver (Ag), magnesium (Mg), copper (Cu), aluminium (Al), platinum (Pt), palladium (Pd), gold (Au), nickel (Ni), neodymium (Nd), iridium (Ir), chromium (Cr), lithium (Li), calcium (Ca), lithium fluoride (LiF), molybdenum (Mo), titanium (Ti), tungsten (W), indium (In), tin (Sn), and zinc (Zn), one or more compounds each being of two or more selected therefrom, one or more mixtures each being of two or more selected therefrom, and/or one or more oxides thereof.

When the first electrode EL1 is the transmissive electrode, the first electrode EL1 may include a transparent metal oxide such as indium tin oxide (ITO), indium zinc oxide (IZO), zinc oxide (ZnO), and/or indium tin zinc oxide (ITZO). When the first electrode EL1 is the transflective electrode or the reflective electrode, the first electrode EL1 may include Ag, Mg, Cu, Al, Pt, Pd, Au, Ni, Nd, Ir, Cr, Li, Ca, LiF/Ca (a stacked structure of LiF and Ca), LiF/Al (a stacked structure of LiF and Al), Mo, Ti, W, a compound thereof, or a mixture thereof (*e.g.,* a mixture of Ag and Mg). In some embodiments, the first electrode EL1 may have a multilayer structure including a reflective film or a transflective film formed of one or more of the above-described materials, and a transparent conductive film formed of ITO, IZO, ZnO, ITZO, *etc.* For example, in some embodiments, the first electrode EL1 may have a three-layer structure of ITO/Ag/ITO, but embodiments of the present disclosure are not limited thereto. In one or more embodiments, the first electrode EL1 may include one of the above-described metal materials, any combination of at least two metal materials of the above-described metal materials, oxides of the above-described metal materials, and/or the like. A thickness of the first electrode EL1 may be from about 700 Å to about 10,000 Å. For example, in some embodiments, the thickness of the first electrode EL1 may be from about 1,000 Å to about 3,000 Å.

The hole transport region HTR is provided on the first electrode EL1. The hole transport region HTR may include at least one of a hole injection layer HIL, a hole transport layer HTL, a buffer layer or an emission-auxiliary layer, or an electron blocking layer EBL. A thickness of the hole transport region HTR may be, for example, from about 50 Å to about 15,000 Å.

The hole transport region HTR may have a single layer formed of a single material, a single layer formed of a plurality of different materials, or a multilayer structure including a plurality of layers formed of a plurality of different materials.

For example, in one or more embodiments, the hole transport region HTR may have a single layer structure of a hole injection layer HIL or a hole transport layer HTL, or may have a single layer structure formed of a hole injection material and a hole transport material. In some embodiments, the hole transport region HTR may have a single layer structure formed of a plurality of different materials, or a structure in which a hole injection layer HIL/hole transport layer HTL, a hole injection layer HIL/hole transport layer HTL/buffer layer, a hole injection layer HIL/buffer layer, a hole transport layer HTL/buffer layer, or a hole injection layer HIL/hole transport layer HTL/electron blocking layer EBL are stacked in order (*e.g.,* in the stated order) from the first electrode EL1, but embodiments of the present disclosure are not limited thereto.

The hole transport region HTR may be formed utilizing one or more suitable methods such as a vacuum deposition method, a spin coating method, a casting method, a Langmuir-Blodgett (LB) method, an inkjet printing method, a laser printing method, and/or a laser induced thermal imaging (LITI) method.

In one or more embodiments, the hole transport region HTR may include a compound represented by Formula H-1:

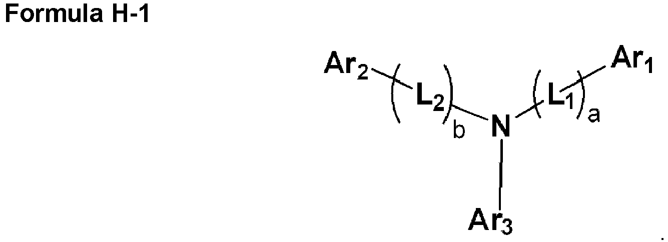

In Formula H-1, L₁ and L₂ may each independently be a direct linkage, a substituted or unsubstituted arylene group having 6 to 30 ring-forming carbon atoms, or a substituted or unsubstituted heteroarylene group having 2 to 30 ring-forming carbon atoms, a and b may each independently be an integer of 0 to 10. In some embodiments, when a or b is an integer of 2 or greater, a plurality of L₁'s and L₂'s may each independently be a substituted or unsubstituted arylene group having 6 to 30 ring-forming carbon atoms, or a substituted or unsubstituted heteroarylene group having 2 to 30 ring-forming carbon atoms.

In Formula H-1, Ar₁ and Ar₂ may each independently be a substituted or unsubstituted aryl group having 6 to 30 ring-forming carbon atoms, or a substituted or unsubstituted heteroaryl group having 2 to 30 ring-forming carbon atoms. In some embodiments, in Formula H-1, Ar₃ may be a substituted or unsubstituted aryl group having 6 to 30 ring-forming carbon atoms, or a substituted or unsubstituted heteroaryl group having 2 to 30 ring-forming carbon atoms.

The compound represented by Formula H-1 may be a monoamine compound. In some embodiments, the compound represented by Formula H-1 may be a diamine compound in which at least one selected from among Ar₁ to Ar₃ may include an amine group as a substituent. In some embodiments, the compound represented by Formula H-1 may be a carbazole-based compound including a substituted or unsubstituted carbazole group in at least one of Ar₁ or Ar₂, or a fluorene-based compound including a substituted or unsubstituted fluorene group in at least one of Ar₁ or Ar₂.

The compound represented by Formula H-1 may be any one selected from among compounds in Compound Group H. However, the compounds listed in Compound Group H are mere examples, and the compounds represented by Formula H-1 are not limited to those represented in Compound Group H:

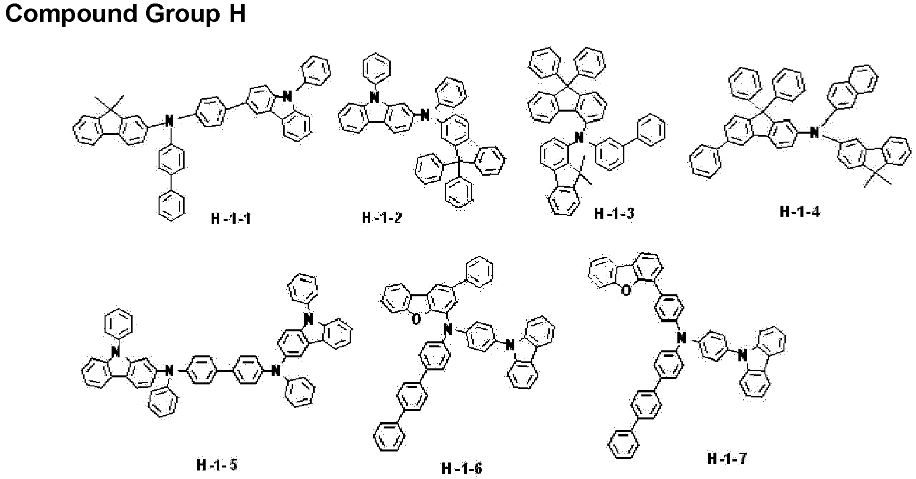

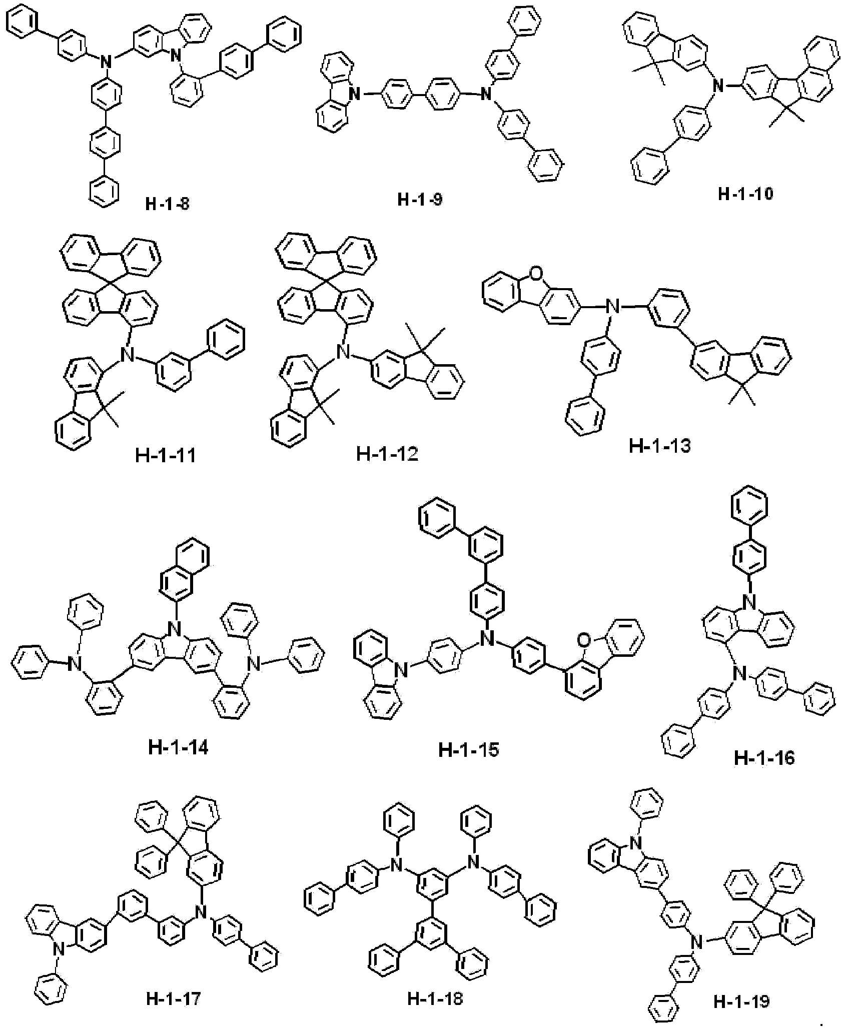

In one or more embodiments, the hole transport region HTR may include at least one selected from among a phthalocyanine compound such as copper phthalocyanine, N¹,N^{1'}-([1,1'-biphenyl]-4,4'-diyl)bis(N¹-phenyl-N⁴,N⁴-di-m-tolylbenzene-1,4-diamine) (DNTPD), 4,4',4"-[tris(3-methylphenyl)phenylamino] triphenylamine (m-MTDATA), 4,4',4"-tris(N,N-diphenylamino)triphenylamine (TDATA), 4,4',4"-tris[N(2-naphthyl)-N-phenylamino]-triphenylamine (2-TNATA), poly(3,4-ethylenedioxythiophene)/poly(4-styrenesulfonate) (PEDOT/PSS), polyaniline/dodecylbenzenesulfonic acid (PANI/DBSA), polyaniline/camphor sulfonic acid (PANI/CSA), polyaniline/poly(4-styrenesulfonate) (PANI/PSS), N,N'-di(naphthalen-1-yl)-N,N'-diphenyl-benzidine (NPB), triphenylamine-containing polyetherketone (TPAPEK), 4-isopropyl-4'-methyldiphenyliodonium [tetrakis(pentafluorophenyl)borate], dipyrazino[2,3-f: 2' ,3'-h]quinoxaline-2,3,6, 7,10, 11-hexacarbonitrile (HATCN), *etc.*

In one or more embodiments, the hole transport region HTR may include at least one selected from among a carbazole-based derivative such as N-phenyl carbazole or polyvinyl carbazole, a fluorene-based derivative, a triphenylamine-based derivative such as N,N'-bis(3-methylphenyl)-N,N'-diphenyl-[1,1-biphenyl]-4,4'-diamine (TPD) or 4,4',4"-tris(N-carbazolyl)triphenylamine (TCTA), N,N'-di(naphthalen-1-yl)-N,N'-diphenyl-benzidine (NPB), 4,4'-cyclohexylidene bis[N,N-bis(4-methylphenyl]benzenamine] (TAPC), 4,4'-bis[N,N'-(3-tolyl)amino]-3,3'-dimethylbiphenyl (HMTPD), 1,3-bis(N-carbazolyl)benzene (mCP), *etc.*

In some embodiments, the hole transport region HTR may include at least one selected from among 9-(4-*tert*-butylphenyl)-3,6-bis(triphenylsilyl)-9H-carbazole (CzSi), 9-phenyl-9H-3,9'-bicarbazole (CCP), 1,3-bis(1,8-dimethyl-9H-carbazol-9-yl)benzene (mDCP), *etc.*

The hole transport region HTR may include at least one of the above-described compounds of the hole transport region in at least one of a hole injection layer HIL, a hole transport layer HTL, or an electron blocking layer EBL.

A thickness of the hole transport region HTR may be from about 100 Å to about 10,000 Å, for example, from about 100 Å to about 5,000 Å. When the hole transport region HTR includes a hole injection layer HIL, the hole injection layer HIL may have, for example, a thickness of about 30 Å to about 1,000 Å. When the hole transport region HTR includes a hole transport layer HTL, the hole transport layer HTL may have a thickness of about 250 Å to about 1,000 Å. For example, when the hole transport region HTR includes an electron blocking layer EBL, the electron blocking layer EBL may have a thickness of about 10 Å to about 1,000 Å. When the thicknesses of the hole transport region HTR, the hole injection layer HIL, the hole transport layer HTL, and the electron blocking layer EBL satisfy the above-described ranges, satisfactory hole transport properties may be achieved without a substantial increase in driving voltage.

In one or more embodiments, the hole transport region HTR may further include a charge generating material to increase conductivity in addition to the above-described materials. The charge generating material may be dispersed substantially uniformly or non-uniformly in the hole transport region HTR. The charge generating material may be, for example, a p-dopant. The p-dopant may include at least one of a halogenated metal compound, a quinone derivative, a metal oxide, or a cyano group-containing compound, but embodiments of the present disclosure are not limited thereto. For example, in some embodiments, the p-dopant may include at least one selected from among a metal halide compound such as Cul and/or Rbl, a quinone derivative such as tetracyanoquinodimethane (TCNQ) and/or 2,3,5,6-tetrafluoro-7,7,8,8-tetracyanoquinodimethane (F4-TCNQ), a metal oxide such as tungsten oxide and/or molybdenum oxide, a cyano group-containing compound such as dipyrazino[2,3-f: 2',3'-h] quinoxaline-2,3,6,7,10,11-hexacarbonitrile (HATCN) and/or 4-[[2,3-bis[cyano-(4-cyano-2,3,5,6-tetrafluorophenyl)methylidene]cyclopropylidene]-cyanomethyl]-2,3,5,6-tetrafluorobenzonitrile (NDP9), *etc.,* but embodiments of the present disclosure are not limited thereto.

As described above, the hole transport region HTR may further include at least one of the buffer layer or the electron blocking layer EBL in addition to the hole injection layer HIL and the hole transport layer HTL. The buffer layer may compensate for a resonance distance according to the wavelength of light emitted from the emission layer EML and may thus increase light emission efficiency. A material that may be included in the hole transport region HTR may be utilized as a material to be included in the buffer layer. The electron blocking layer EBL is a layer that serves to prevent or reduce the electron injection from the electron transport region ETR to the hole transport region HTR.

The emission layer EML is provided on the hole transport region HTR. The emission layer EML may have a thickness of, for example, about 100 Å to about 1,000 Å or about 100 Å to about 300 Å. The emission layer EML may have a single layer formed of a single material, a single layer formed of a plurality of different materials, or a multilayer structure having a plurality of layers formed of a plurality of different materials.

In the light emitting element ED of one or more embodiments, the emission layer EML may include an anthracene derivative, a pyrene derivative, a fluoranthene derivative, a chrysene derivative, a dihydrobenzanthracene derivative, or a triphenylene derivative. For example, in some embodiments, the emission layer EML may include the anthracene derivative or the pyrene derivative.

In each light emitting element ED of one or more embodiments illustrated in FIGs. 3 to 6, the emission layer EML may further include a suitable host and dopant, and, for example, in some embodiments, the emission layer EML may include a compound represented by Formula E-1. The compound represented by Formula E-1 may be utilized as a fluorescent host material.

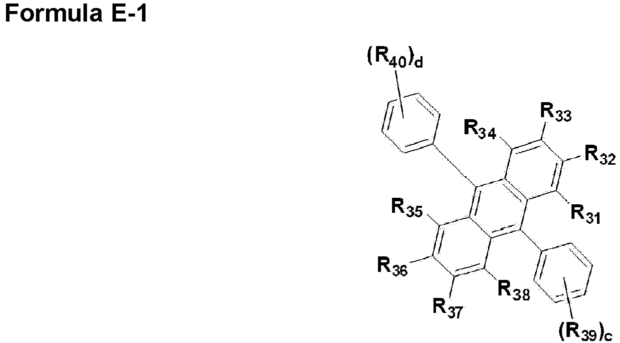

In Formula E-1, R₃₁ to R₄₀ may each independently be hydrogen, deuterium, a halogen, a substituted or unsubstituted silyl group, a substituted or unsubstituted thio group, a substituted or unsubstituted oxy group, a substituted or unsubstituted alkyl group having 1 to 10 carbon atoms, a substituted or unsubstituted alkenyl group having 2 to 10 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form a ring. In some embodiments, one or more selected from R₃₁ to R₄₀ may each independently be bonded to an adjacent group to form a saturated hydrocarbon ring or an unsaturated hydrocarbon ring, a saturated heterocycle, or an unsaturated heterocycle.

In Formula E-1, c and d may each independently be an integer of 0 to 5.

The compound represented by Formula E-1 may be any one selected from among Compound E1 to Compound E19:

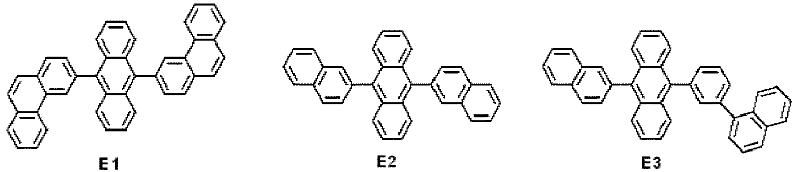

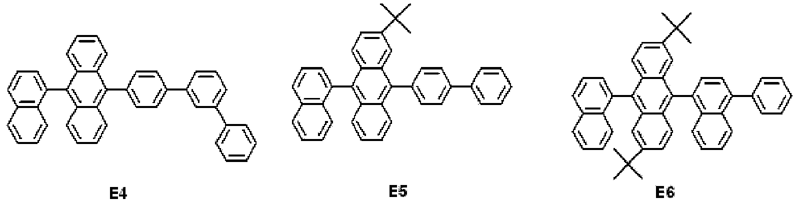

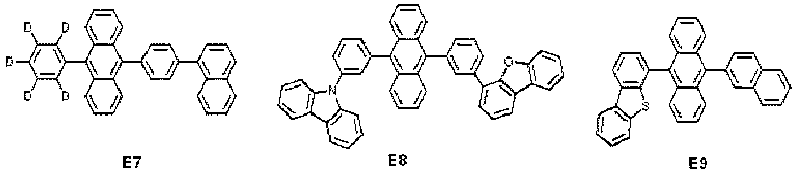

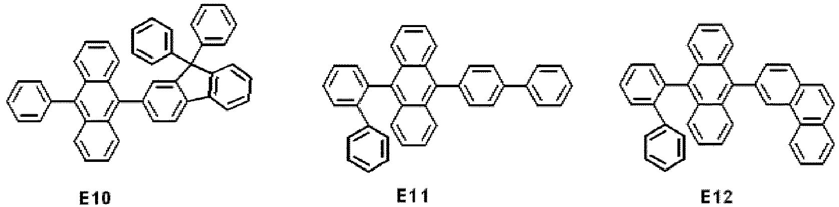

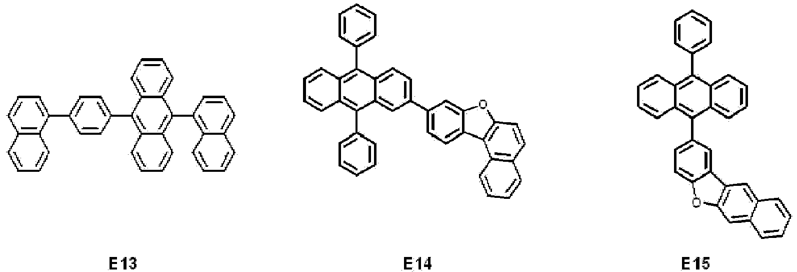

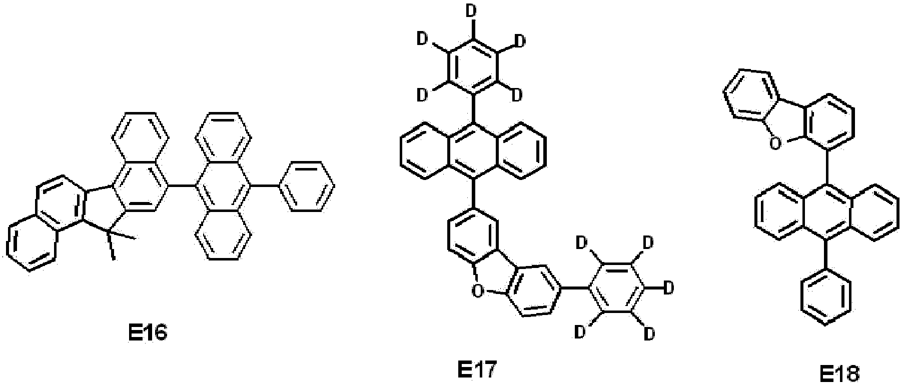

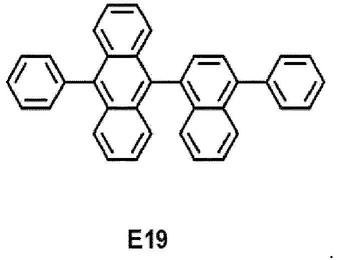

In one or more embodiments, the emission layer EML may include a compound represented by Formula E-2a or Formula E-2b. The compound represented by Formula E-2a or Formula E-2b may be utilized as a phosphorescent host material.

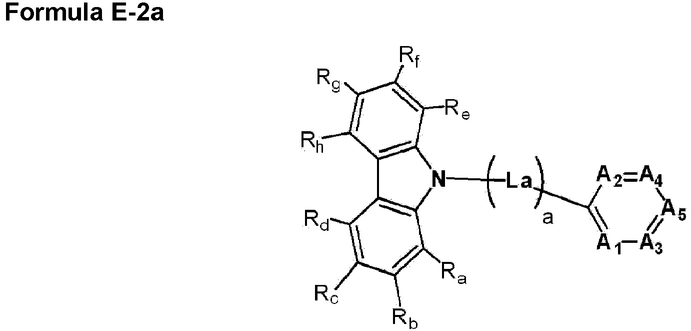

In Formula E-2a, a may be an integer of 0 to 10, and Lₐ may be a direct linkage, a substituted or unsubstituted arylene group having 6 to 30 ring-forming carbon atoms, or a substituted or unsubstituted heteroarylene group having 2 to 30 ring-forming carbon atoms. In some embodiments, when a is an integer of 2 or greater, a plurality of Lₐ's may each independently be a substituted or unsubstituted arylene group having 6 to 30 ring-forming carbon atoms, or a substituted or unsubstituted heteroarylene group having 2 to 30 ring-forming carbon atoms.

In some embodiments, in Formula E-2a, A₁ to A₅ may each independently be N or CRᵢ. Rₐ to Rᵢ may each independently be hydrogen, deuterium, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form a ring. In one or more embodiments, one or more selected from among Rₐ to Rᵢ may each independently be bonded to an adjacent group to form a hydrocarbon ring or a heterocycle containing N, O, S, *etc.,* as a ring-forming atom.

In some embodiments, in Formula E-2a, two or three selected from among A₁ to A₅ may be N, and the rest may be CRᵢ.

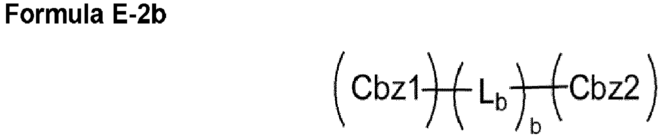

In Formula E-2b, Cbz1 and Cbz2 may each independently be an unsubstituted carbazole group, or a carbazole group substituted with an aryl group having 6 to 30 ring-forming carbon atoms. L_{b} may be a direct linkage, a substituted or unsubstituted arylene group having 6 to 30 ring-forming carbon atoms, or a substituted or unsubstituted heteroarylene group having 2 to 30 ring-forming carbon atoms. b may be an integer of 0 to 10, and when b is an integer of 2 or more, a plurality of L_{b}'s may each independently be a substituted or unsubstituted arylene group having 6 to 30 ring-forming carbon atoms, or a substituted or unsubstituted heteroarylene group having 2 to 30 ring-forming carbon atoms.

The compound represented by Formula E-2a or Formula E-2b may be any one selected from among compounds of Compound Group E-2. However, the compounds listed in Compound Group E-2 are mere examples, and the compound represented by Formula E-2a or Formula E-2b is not limited to those represented in Compound Group E-2.

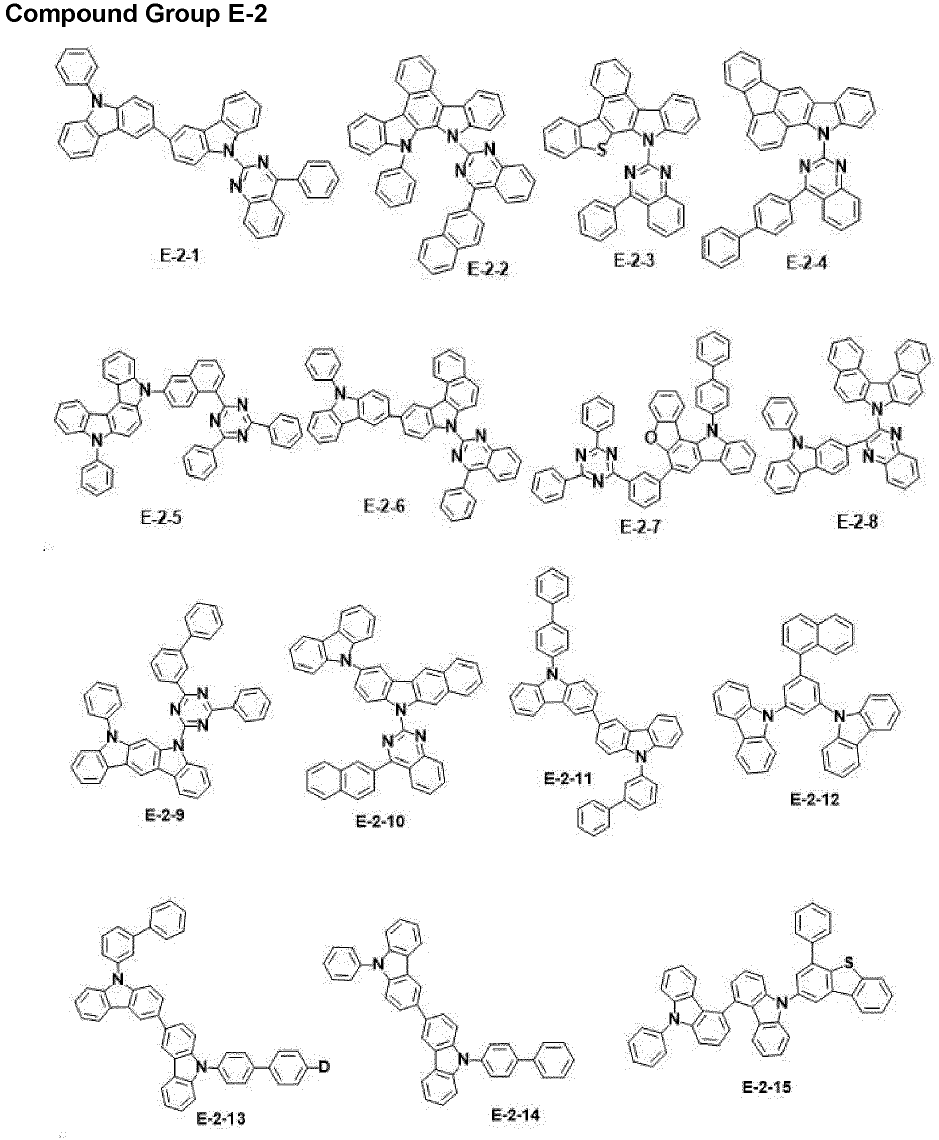

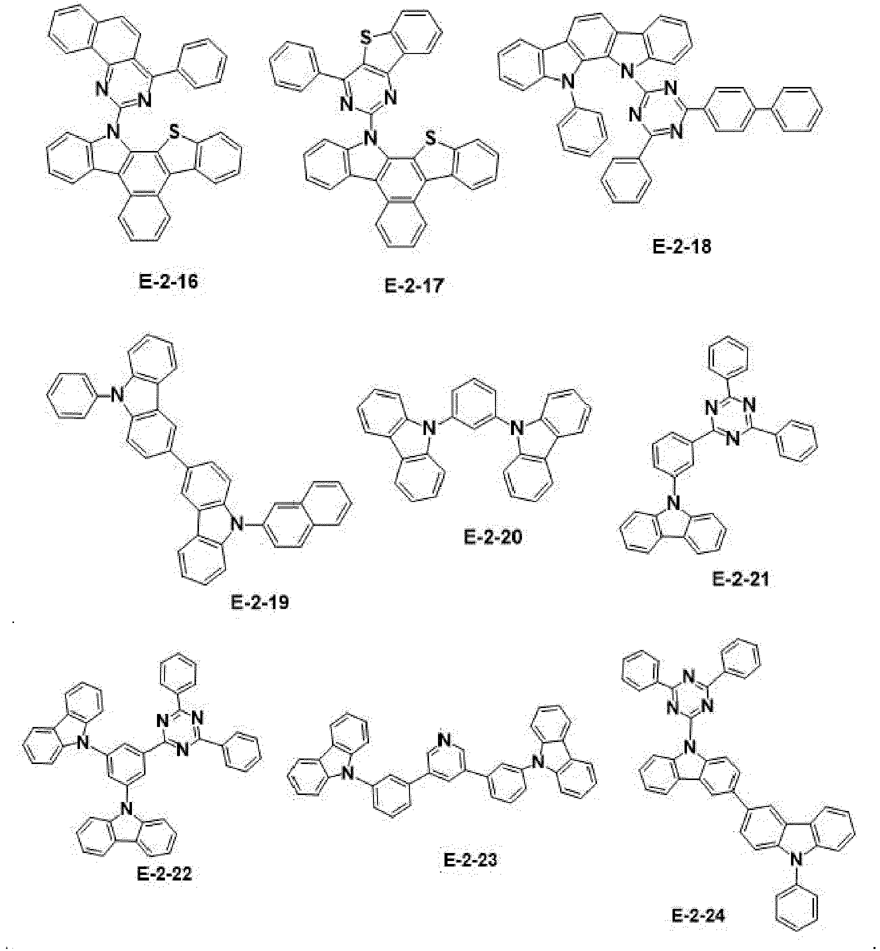

In one or more embodiments, the emission layer EML may further include a material suitable in the art as a host material. For example, the emission layer EML may include, as a host material, at least one of bis(4-(9H-carbazol-9-yl)phenyl)diphenylsilane (BCPDS), (4-(1-(4-(diphenylamino)phenyl)cyclohexyl)phenyl)diphenyl-phosphine oxide (POPCPA), bis[2-(diphenylphosphino)phenyl]ether oxide (DPEPO), 4,4'-bis(N-carbazolyl)-1,1'-biphenyl (CBP), 1,3-bis(carbazol-9-yl)benzene (mCP), 2,8-bis(diphenylphosphoryl)dibenzo[b,d]furan (PPF), 4,4',4"-tris(carbazol-9-yl)-triphenylamine (TCTA), or 1,3,5-tris(1-phenyl-1H-benzo[d]imidazol-2-yl)benzene (TPBi). However, embodiments of the present disclosure are not limited thereto, for example, tris(8-hydroxyquinolino)aluminium (Alqs), 9,10-di(naphthalen-2-yl)anthracene (ADN), 2-*tert*-butyl-9,10-di(naphth-2-yl)anthracene (TBADN), distyrylarylene (DSA), 4,4'-bis(9-carbazolyl)-2,2'-dimethyl-biphenyl (CDBP), 2-methyl-9,10-bis(naphthalen-2-yl)anthracene (MADN), hexaphenyl cyclotriphosphazene (CP1), 1,4-bis(triphenylsilyl)benzene (UGH2), hexaphenylcyclotrisiloxane (DPSiOs), octaphenylcyclotetrasiloxane (DPSiO₄), *etc.* may be utilized as a host material.

In one or more embodiments, the emission layer EML may include a compound represented by Formula M-a or Formula M-b. The compound represented by Formula M-a or Formula M-b may be utilized as a phosphorescent dopant material.

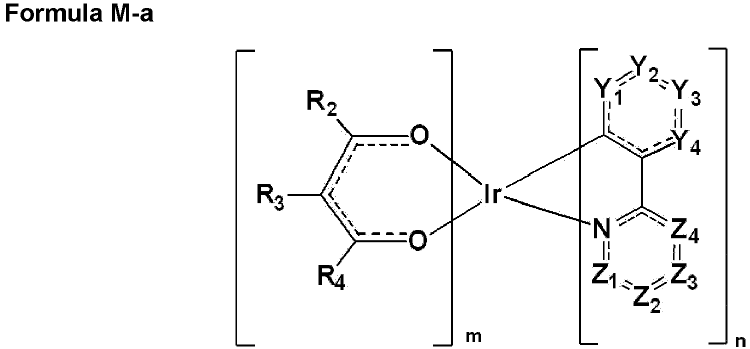

In Formula M-a, Y₁ to Y₄ and Z₁ to Z₄ may each independently be CR₁ or N, R₁ to R₄ may each independently be hydrogen, deuterium, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form a ring. In Formula M-a, m is 0 or 1, and n is 2 or 3. In Formula M-a, when m is 0, n is 3, and when m is 1, n is 2.

The compound represented by Formula M-a may be utilized as a phosphorescent dopant.

The compound represented by Formula M-a may be any one selected from among Compound M-a1 to Compound M-a25. However, Compounds M-a1 to M-a25 are mere examples, and the compound represented by Formula M-a is not limited to those represented by Compounds M-a1 to M-a25.

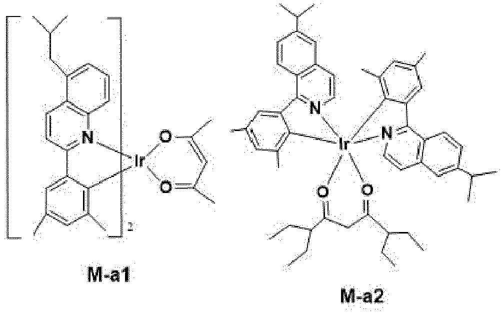

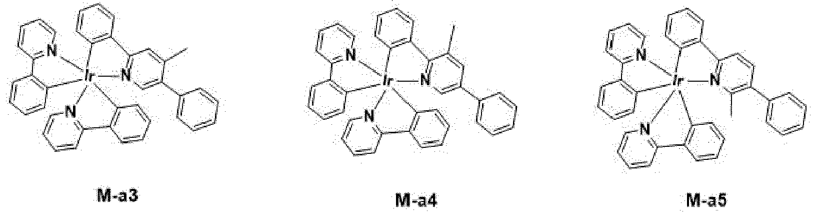

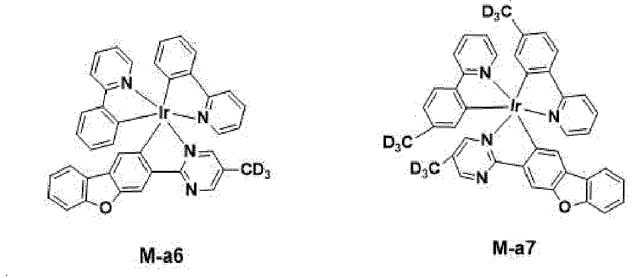

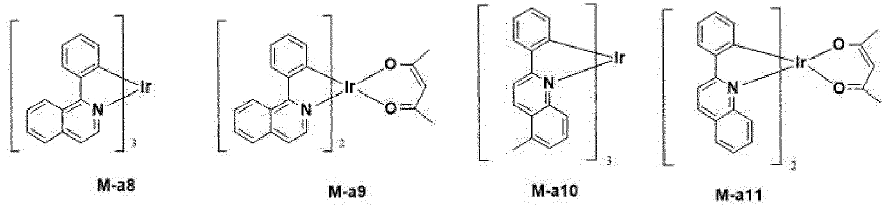

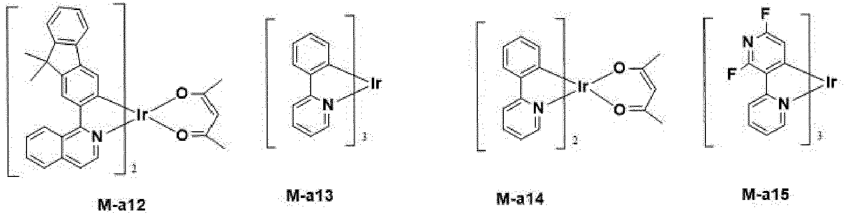

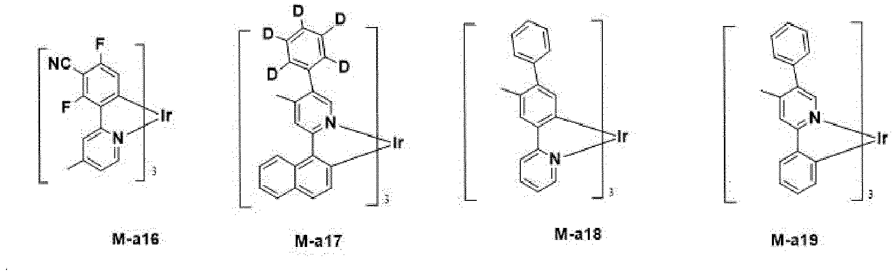

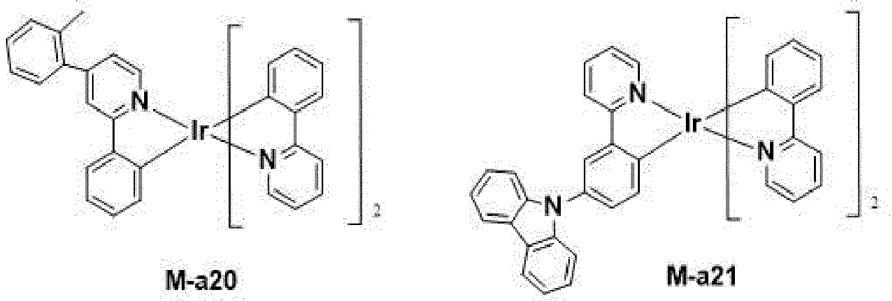

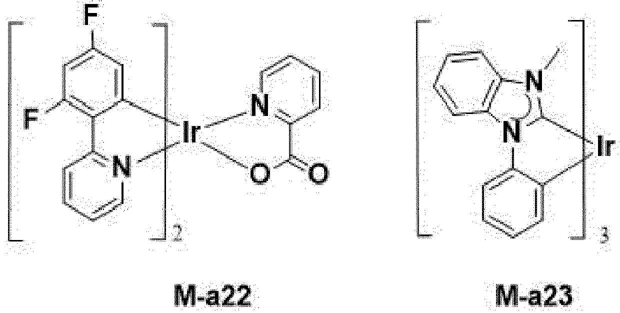

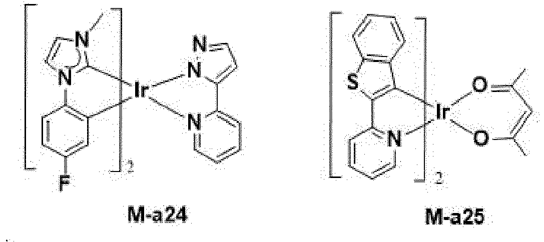

In one or more embodiments, the compound M-a1 and the compound M-a2 may be utilized as a red dopant material, and the compound M-a3 to the compound Ma7 may be utilized as a green dopant material.

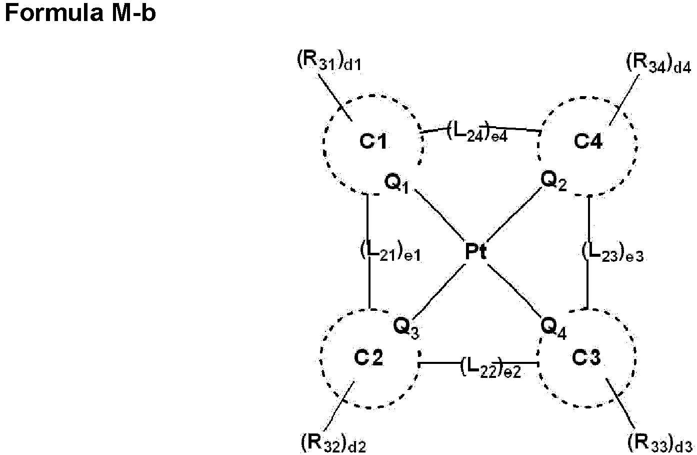

In Formula M-b, Q₁ to Q₄ may each independently be C or N, and C1 to C4 may each independently be a substituted or unsubstituted hydrocarbon ring having 5 to 30 ring-forming carbon atoms, or a substituted or unsubstituted hetero ring having 2 to 30 ring-forming carbon atoms. L₂₁ to L₂₄ may each independently be a direct linkage, 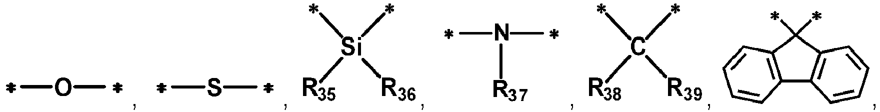 a substituted or unsubstituted alkylene group having 1 to 20 carbons, a substituted or unsubstituted arylene group having 6 to 30 ring-forming carbon atoms, or a substituted or unsubstituted heteroarylene group having 2 to 30 ring-forming carbon atoms, and e1 to e4 may each independently be 0 or 1. R₃₁ to R₃₉ may each independently be hydrogen, deuterium, a halogen, a cyano group, a substituted or unsubstituted amine group, a substituted or unsubstituted alkyl group having 1 to 20 carbons, a substituted or unsubstituted aryl group having 6 to 30 ring-forming carbon atoms, or a substituted or unsubstituted heteroaryl group having 2 to 30 ring-forming carbon atoms, and/or forms a ring by being coupled to an adjacent group, and d1 to d4 may each independently be an integer of 0 to 4.

The compound represented by Formula M-b may be utilized as a blue phosphorescent dopant or a green phosphorescent dopant. In some embodiments, the compound represented by Formula M-b may further be included in the light emitting layer EML as an auxiliary dopant.

The compound represented by Formula M-b may be any one of compound M-b-1 to compound M-b-11. However, the compounds below are only mere examples, and the compound represented by Formula M-b is not limited to the compound M-b-1 to the compound M-b-11.

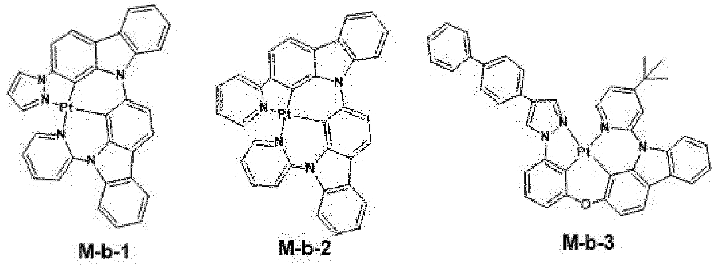

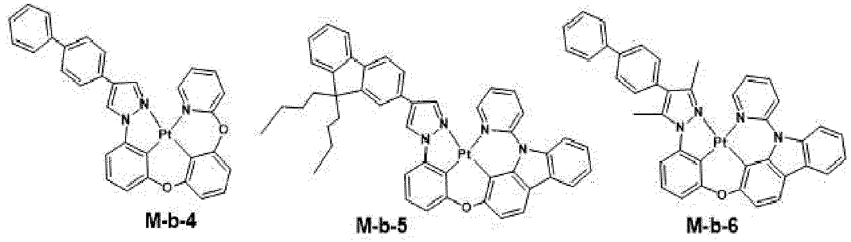

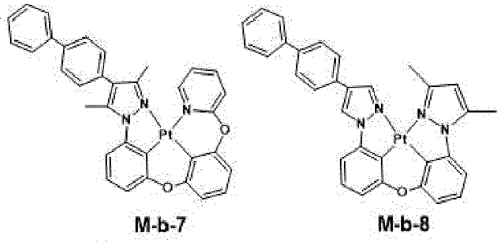

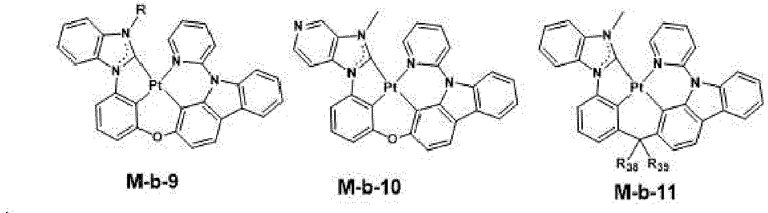

In the compounds above, R, R₃₈, and R₃₉ may each independently be hydrogen, deuterium, a halogen, a cyano group, a substituted or unsubstituted amine group, a substituted or unsubstituted alkyl group having 1 to 20 carbons, a substituted or unsubstituted aryl group having 6 to 30 ring-forming carbon atoms, or a substituted or unsubstituted heteroaryl group having 2 to 30 ring-forming carbon atoms.

In one or more embodiments, the emission layer EML may include a compound represented by any one selected from among Formula F-a to Formula F-c. The compound represented by Formula F-a to Formula F-c may be utilized as a fluorescence dopant material.

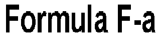

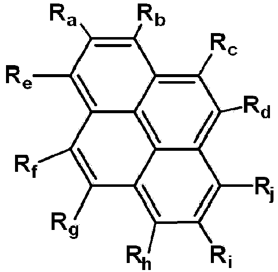

In Formula F-a, two selected from among Rₐ to Rⱼ may each independently be substituted with *-RAr₁Ar₂ The others, which are not substituted with *-NAr₁Ar₂, among Rₐ to Rⱼ may each independently be hydrogen, deuterium, a halogen, a cyano group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms.

In *-NAr₁Ar₂, Ar₁ and Ar₂ may each independently be a substituted or unsubstituted aryl group having 6 to 30 ring-forming carbon atoms, or a substituted or unsubstituted heteroaryl group having 2 to 30 ring-forming carbon atoms. For example, in some embodiments, at least one of Ar₁ or Ar₂ may be a heteroaryl group containing O or S as a ring-forming atom.

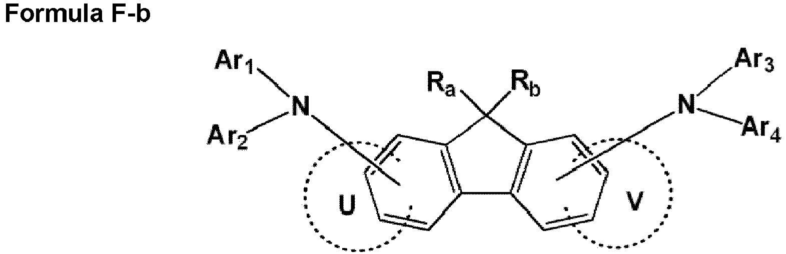

In Formula F-b, Rₐ and R_{b} may each independently be hydrogen, deuterium, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form a ring. Ar₁ to Ar₄ may each independently be a substituted or unsubstituted aryl group having 6 to 30 ring-forming carbon atoms, or a substituted or unsubstituted heteroaryl group having 2 to 30 ring-forming carbon atoms.

In Formula F-b, U and V may each independently be a substituted or unsubstituted hydrocarbon ring having 5 to 30 ring-forming carbon atoms, or a substituted or unsubstituted heterocycle having 2 to 30 ring-forming carbon atoms. In some embodiments, at least one selected from among Ar₁ to Ar₄ may be a heteroaryl group containing O or S as a ring-forming atom.

In Formula F-b, the number of rings represented by U and V may each independently be 0 or 1. For example, in Formula F-b, it refers to that when the number of U or V is 1, one ring constitutes a fused ring at a portion indicated by U or V, and when the number of U or V is 0, a ring indicated by U or V does not exist. For example, when the number of U is 0 and the number of V is 1, or when the number of U is 1 and the number of V is 0, the fused ring having a fluorene core in Formula F-b may be a cyclic compound having four rings. In some embodiments, when each number of U and V is 0, the fused ring in Formula F-b may be a cyclic compound having three rings. In some embodiments, when each number of U and V is 1, the fused ring having a fluorene core in Formula F-b may be a cyclic compound having five rings.

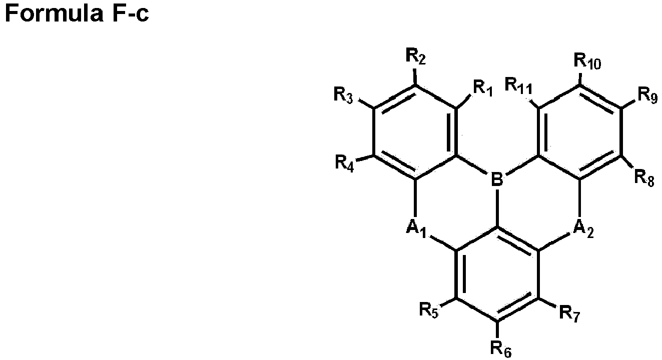

In Formula F-c, A₁ and A₂ may each independently be O, S, Se, or NRₘ, and Rₘ may be hydrogen, deuterium, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. R₁ to R₁₁ may each independently be hydrogen, deuterium, a halogen, a cyano group, a substituted or unsubstituted amine group, a substituted or unsubstituted boryl group, a substituted or unsubstituted oxy group, a substituted or unsubstituted thio group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form a ring.

In one or more embodiments, in Formula F-c, A₁ and A₂ may each independently be bonded to substituents of an adjacent ring to form a fused ring. For example, when A₁ and A₂ may each independently be NRₘ, A₁ may be bonded to R₄ or R₅ to form a ring. In some embodiments, A₂ may be bonded to R₇ or R₈ to form a ring.

In one or more embodiments, the emission layer EML may further include, as a suitable dopant material, one or more selected from among a styryl derivative (e.g., 1,4-bis[2-(3-N-ethylcarbazolyl)vinyl]benzene (BCzVB), 4-(di-p-tolylamino)-4'-[(dip-tolylamino)styryl]stilbene (DPAVB), and N-(4-((E)-2-(6-((E)-4-(diphenylamino)styryl)naphthalen-2-yl)vinyl)phenyl)-N-phenylbenzenamine (N-BDAVBi), 4,4'-bis[2-(4-(N,N-diphenylamino)phenyl)vinyl]biphenyl (DPAVBi), perylene and a derivative thereof (e.g., 2,5,8,11-tetra-t-butylperylene (TBP)), pyrene and a derivative thereof (e.g., 1,1-dipyrene, 1,4-dipyrenylbenzene, 1,4-bis(N,N-diphenylamino)pyrene), *etc.*

In one or more embodiments, the emission layer EML may further include a suitable phosphorescence dopant material. For example, a metal complex containing iridium (Ir), platinum (Pt), osmium (Os), gold (Au), titanium (Ti), zirconium (Zr), hafnium (Hf), europium (Eu), terbium (Tb), or thulium (Tm) may be utilized as a phosphorescent dopant. For example, in some embodiments, iridium(III) bis(4,6-difluorophenylpyridinato-C², N) (FIrpic), bis(2,4-difluorophenylpyridinato)-tetrakis(1-pyrazolyl)borate iridium(III) (FIr6), or platinum octaethyl porphyrin (PtOEP) may be utilized as a phosphorescent dopant. However, embodiments of the present disclosure are not limited thereto.

In one or more embodiments, the emission layer EML may include a quantum dot material. In one or more embodiments, the quantum dot material may have a core/shell structure. The core of the quantum dot may be selected from a Group II-VI compound, a Group III-VI compound, a Group I-III-IV compound, a Group III-V compound, a Group III-II-V compound, a Group IV-VI compound, a Group IV element, a Group IV compound, and one or more combinations thereof.

The Group II-VI compound may be selected from the group consisting of a binary compound selected from the group consisting of CdSe, CdTe, CdS, ZnS, ZnSe, ZnTe, ZnO, HgS, HgSe, HgTe, MgSe, MgS, and one or more mixtures (and/or combinations) thereof, a ternary compound selected from the group consisting of CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and one or more mixtures (and/or combinations) thereof, and a quaternary compound selected from the group consisting of HgZnTeS, CdZnSeS, CdZnSeTe, CdZnSTe, CdHgSeS, CdHgSeTe, CdHgSTe, HgZnSeS, HgZnSeTe, HgZnSTe, and one or more mixtures (and/or combinations) thereof.

The Group III-VI compound may include a binary compound such as In₂S₃ and/or In₂Se₃, a ternary compound such as InGaSs and/or InGaSes, or any combination thereof.

The Group I-III-VI compound may be selected from a ternary compound selected from the group consisting of AgInS, AgInS₂, CuInS, CuInS₂, AgGaS₂, CuGaS₂ CuGaO₂, AgGaO₂, AgAIO₂, and one or more mixtures (and/or combinations) thereof, and/or a quaternary compound such as AgInGaS₂ and/or CuInGaS₂.

The Group III-V compound may be selected from the group consisting of a binary compound selected from the group consisting of GaN, GaP, GaAs, GaSb, AlN, AlP, AlAs, AlSb, InN, InP, InAs, InSb, and one or more mixtures (and/or combinations) thereof, a ternary compound selected from the group consisting of GaNP, GaNAs, GaNSb, GaPAs, GaPSb, AlNP, AlNAs, AlNSb, AlPAs, AlPSb, InGaP, InAlP, InNP, InNAs, InNSb, InPAs, InPSb, and one or more mixtures (and/or combinations) thereof, and a quaternary compound selected from the group consisting of GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and one or more mixtures (and/or combinations) thereof. In some embodiments, the Group III-V compound may further include a Group II metal. For example, InZnP, *etc.,* may be selected as a Group III-II-V compound.

The Group IV-VI compound may be selected from the group consisting of a binary compound selected from the group consisting of SnS, SnSe, SnTe, PbS, PbSe, PbTe, and one or more mixtures (and/or combinations) thereof, a ternary compound selected from the group consisting of SnSeS, SnSeTe, SnSTe, PbSeS, PbSeTe, PbSTe, SnPbS, SnPbSe, SnPbTe, and one or more mixtures (and/or combinations) thereof, and a quaternary compound selected from the group consisting of SnPbSSe, SnPbSeTe, SnPbSTe, and one or more mixtures (and/or combinations) thereof. The Group IV element may be selected from the group consisting of Si, Ge, and a mixture thereof. The Group IV compound may be a binary compound selected from the group consisting of SiC, SiGe, and a mixture thereof.

Each element included in a polynary compound such as the binary compound, the ternary compound, or the quaternary compound may be present in a particle with a substantially uniform or non-uniform concentration distribution. For example, the aforementioned formulae may refer to the types (kinds) of elements included in the compounds, and the elemental ratio in the compound may be different. For example, AgInGaS₂ may refer to AgInₓGa₁₋ₓS₂ (where x is a real number of 0 to 1).

In some embodiments, the quantum dot may have a single structure or a double structure of core-shell in which the concentration of each element included in the quantum dot is substantially uniform. For example, the material included in the core may be different from the material included in the shell.

The shell of the quantum dot may serve as a protection layer to prevent or reduce the chemical deformation of the core to maintain semiconductor properties, and/or a charging layer to impart electrophoresis properties to the quantum dot. The shell may be a single layer or multiple layers. An interface between the core and the shell may have a concentration gradient in which the concentration of an element present in the shell becomes lower towards the center.

In some embodiments, the quantum dot may have the above-described core/shell structure including a core containing nanocrystals and a shell around (e.g., surrounding) the core. The shell of the quantum dot may serve as a protection layer to prevent or reduce the chemical deformation of the core to maintain semiconductor properties, and/or a charging layer to impart electrophoresis properties to the quantum dot. The shell may be a single layer or multiple layers. An example of the shell of the quantum dots may include a metal or non-metal oxide, a semiconductor compound, or a combination thereof.

For example, the metal or non-metal oxide suitable as a shell may be a binary compound such as SiO₂, Al₂O₃, TiO₂, ZnO, MnO, Mn₂O₃, Mn₃O₄, CuO, FeO, Fe₂O₃, Fe₃O₄, CoO, Co₃O₄, and/or NiO, and/or a ternary compound such as MgAl₂O₄, CoFe₂O₄, NiFe₂O₄, and/or CoMn₂O₄, but embodiments of the present disclosure are not limited thereto.

Also, examples of the semiconductor compound suitable as a shell may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, *etc.,* but embodiments of the present disclosure are not limited thereto.

Each element included in a polynary compound such as the binary compound, or the ternary compound may be present in a particle with a substantially uniform or non-substantially uniform concentration distribution. For example, the formulae refer to the types (kinds) of elements included in the compounds, and the elemental ratio in the compound may be different.

The quantum dot may have a full width of half maximum (FWHM) of a light emitting wavelength spectrum (*e.g.,* an emission spectrum) of about 45 nm or less, about 40 nm or less, or about 30 nm or less, and color purity or color reproducibility of the quantum dot may be improved within the above range. In some embodiments, light emitted through such quantum dot is emitted in all directions so that a wide viewing angle may be improved.

In some embodiments, the form of the quantum dot is not particularly limited as long as it is a form commonly utilized in the art. The quantum dot in the form of spherical nanoparticles, pyramidal nanoparticles, multi-arm nanoparticles, or cubic nanoparticles, nanotubes, nanowires, nanofibers, nanoplate particles, *etc.* may be utilized.

As the size of the quantum dot is adjusted or the elemental ratio in the quantum dot compound is adjusted, it may control the energy band gap of the quantum dot, and thus light in one or more suitable wavelength ranges may be obtained in a quantum dot emission layer. Therefore, when the quantum dot as above (*e.g.,* utilizing different sizes of quantum dots or different elemental ratios in the quantum dot compound) is utilized, the light emitting device, which emits light in one or more suitable wavelengths, may be implemented. For example, the adjustment of the size of the quantum dot and/or the elemental ratio in the quantum dot compound may be performed to enable the quantum dots to emit red, green, and/or blue light. In some embodiments, the quantum dots may be configured to emit white light by combining one or more suitable colors of light.

In each of the light emitting elements ED of one or more embodiments, shown in FIG. 3 to FIG. 6, an electron transport region ETR is provided on an emission layer EML. The electron transport region ETR may have a multilayer structure having multiple layers formed utilizing multiple different materials. For example, in one or more embodiments, the electron transport region ETR may have a structure stacked in order from the emission layer EML of electron transport layer ETL/first electron injection layer EIL1/second electron injection layer EIL2. In some embodiments, the electron transport region ETR may have a structure stacked in order from the emission layer EML of hole blocking layer HBL/electron transport layer ETL/first electron injection layer EIL1/second electron injection layer EIL2.

A thickness of the electron transport region ETR may be, for example, about 1000 Å to about 1500 Å. In the electron transport region ETR, a thickness of the electron transport layer ETL may be from about 100 Å to about 1000 A, for example, from about 150 Å to about 500 Å. When the thickness of the electron transport layer ETL satisfies the above-described range, satisfactory electron transport properties may be obtained without a substantial increase in driving voltage.

In one or more embodiments, the electron transport region ETR includes a first electron injection layer EIL1 and a second electron injection layer EIL2. The first electron injection layer EIL1 is disposed on the electron transport layer ETL, and the second electron injection layer EIL2 is disposed on the first electron injection layer EIL1. For example, the first electron injection layer may be disposed directly on the electron transport layer ETL, the second electron injection layer EIL2 may be disposed directly on the first electron injection layer EIL1, and on the second electron injection layer EIL2, the second electrode EL2 may be directly disposed.

In one or more embodiments, the first electron injection layer EIL1 includes at least one of a first compound or a second compound. The first electron injection layer EIL1 may include an organic material but may not include (*e.g.,* may exclude) a metal material (*e.g.,* any metal material). In some embodiments, the first electron injection layer EIL1 may be composed of (*e.g.,* may consist (essentially) of) the first compound and/or the second compound. In some embodiments, the first electron injection layer EIL1 may be a mixture layer of the first compound and the second compound. In present disclosure, "not include a or any 'component'" "exclude a or any 'component'", "'component'-free", and/or the like refers to that the "component" not being added, selected or utilized as a component in the composition, but the "component" of less than a suitable amount may still be included due to other impurities and/or external factors.

The second electron injection layer EIL2 includes a metal material. The second electron injection layer EIL2 may include a metal of lanthanoids (*e.g.,* a lanthanide metal) such as Yb. In some embodiments, the second electron injection layer EIL2 may include a metal halide such as LiF, NaCl, CsF, RbCl, Rbl, Cui, and/or KI, or a co-depositing material of the metal halide and the metal of lanthanoids. For example, in some embodiments, the second electron injection layer EIL2 may include KI:Yb, RbI:Yb, LiF:Yb, and/or the like as the co-depositing material. In some embodiments, the second electron injection layer EIL2 may utilize a metal oxide such as Li₂O and/or BaO, or 8-hydroxyl-lithium quinolate (Liq).

The first compound included in the first electron injection layer EIL1 includes a phenanthroline moiety. In one or more embodiments, the first compound may include at least one phenanthroline moiety. In the first compound, one phenanthroline moiety may be included, or two or more phenanthroline moieties may be included. When multiple phenanthroline moieties are included in the first compound, each phenanthroline moiety may be connected via a linker.

In one or more embodiments, the first compound may be represented by Formula 1.

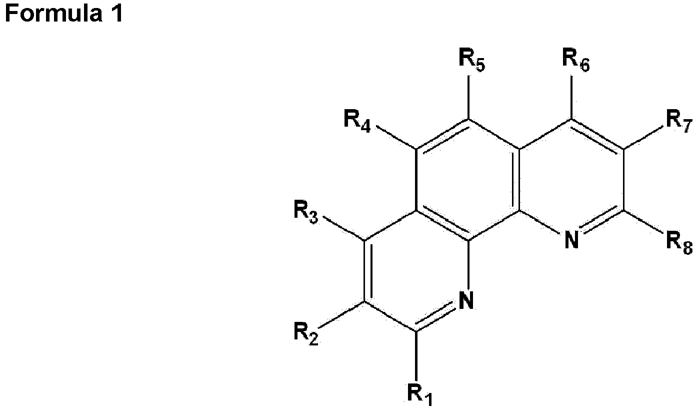

In Formula 1, R₁ to R₈ are each independently hydrogen, deuterium, a halogen, a cyano group, a hydroxyl group, a substituted or unsubstituted oxy group, a substituted or unsubstituted thio group, a substituted or unsubstituted amine group, a substituted or unsubstituted alkyl group of 1 to 20 carbon atoms, a substituted or unsubstituted alkenyl group of 2 to 20 carbon atoms, a substituted or unsubstituted aryl group of 6 to 30 ring-forming carbon atoms, or a substituted or unsubstituted heteroaryl group of 2 to 30 ring-forming carbon atoms. For example, in one or more embodiments, R₁ to R₃, and R₆ to R₈ may each independently be hydrogen, deuterium, a substituted or unsubstituted oxy group, a substituted or unsubstituted amine group, a substituted or unsubstituted aryl group of 6 to 30 ring-forming carbon atoms, or a substituted or unsubstituted heteroaryl group of 2 to 30 ring-forming carbon atoms. For example, in one or more embodiments, R₁ to R₃, and R₆ to R₈ may each independently be hydrogen, deuterium, a substituted or unsubstituted oxy group, a substituted or unsubstituted amine group, a substituted or unsubstituted phenyl group, or a substituted or unsubstituted carbazole group, and R₄ and R₅ may each independently be hydrogen.

The first compound included in the first electron injection layer EIL1 of one or more embodiments may be any one selected from among compounds in Compound Group 1. The first electron injection layer EIL1 of the light emitting element ED of one or more embodiments may include at least one selected from among the compounds shown in Compound Group 1.

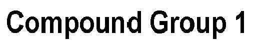

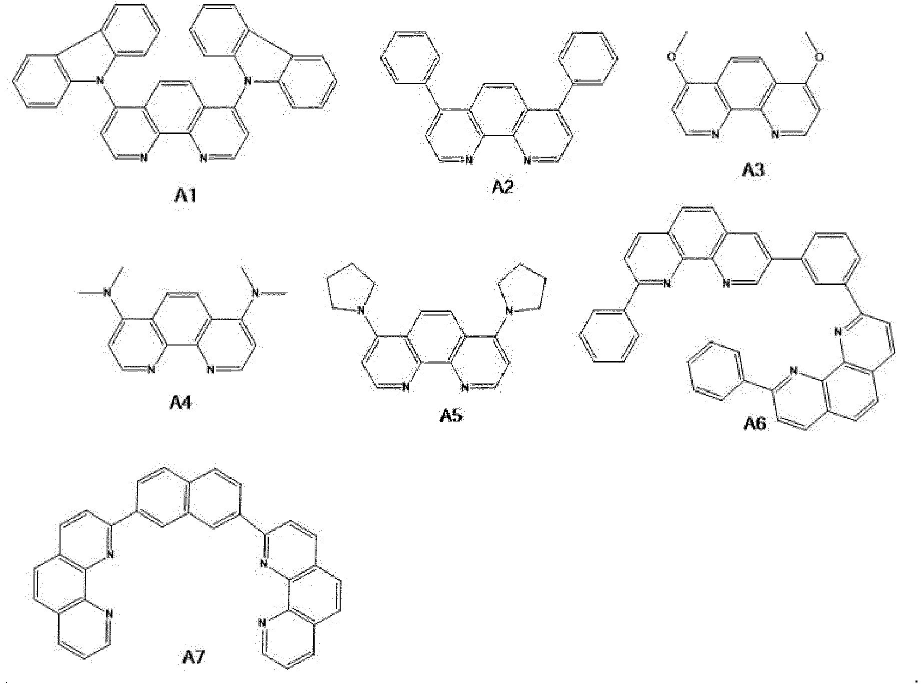

The second compound that may be included in the first electron injection layer EIL1 is a phosphine oxide-based compound. In one or more embodiments, the second compound may be represented by Formula 2.

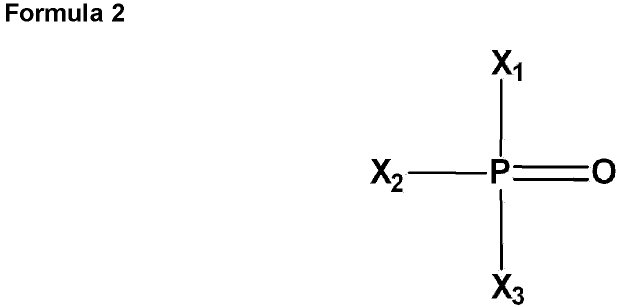

In Formula 2, X₁ to X₃ are each independently hydrogen, deuterium, a substituted or unsubstituted alkyl group of 1 to 20 carbon atoms, a substituted or unsubstituted alkenyl group of 2 to 20 carbon atoms, a substituted or unsubstituted aryl group of 6 to 30 ring-forming carbon atoms, or a substituted or unsubstituted heteroaryl group of 2 to 30 ring-forming carbon atoms. In some embodiments, X₁ to X₃ may each independently be combined with an adjacent group to form a ring. For example, X₁ to X₃ may each independently be a substituted or unsubstituted aryl group of 6 to 30 ring-forming carbon atoms, or a substituted or unsubstituted heteroaryl group of 2 to 30 ring-forming carbon atoms, and/or combined with an adjacent group to form a ring. For example, in some embodiments, X₁ to X₃ may each independently be a substituted or unsubstituted phenyl group, a substituted or unsubstituted naphthyl group, or a substituted or unsubstituted anthracene group. In some embodiments, X₁ corresponds to an unsubstituted naphthyl group, X₂ corresponds to a phenyl group substituted with a naphthyl group, and X₁ and X₂ may form a ring together with the P atom of Formula 2.

The second compound included in the first electron injection layer EIL1 of one or more embodiments may be any one selected from among compounds in Compound Group 2. The first electron injection layer EIL1 of the light emitting element ED of one or more embodiments may include at least one selected from among the compounds shown in Compound Group 2.

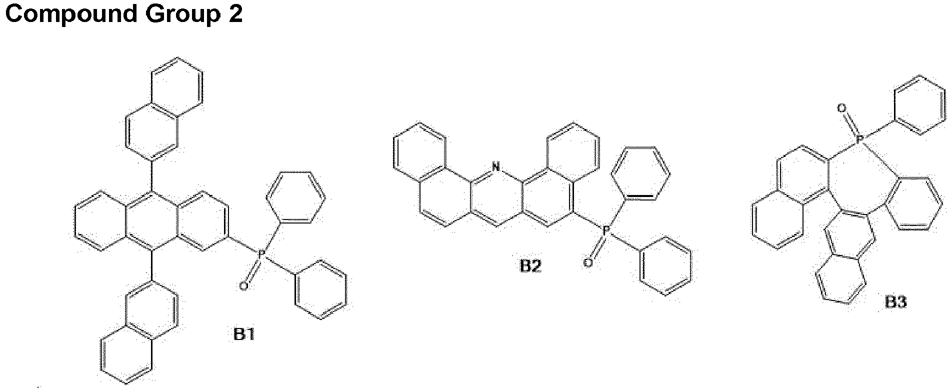

When the first electron injection layer EIL1 includes a metal material other than the first compound and/or the second compound, migration problems of the metal material included in the second electron injection layer EIL2 may occur at a high temperature, and the stability of a light emitting element may become weak and decrease. However, because the first electron injection layer EIL1 of one or more embodiments of the present disclosure includes the first compound and/or the second compound, the migration and aggregation of the metal material included in the second electron injection layer EIL2 may be prevented or reduced, and element stability may be improved, and element lifetime may be increased.

Because the first electron injection layer EIL1 of one or more embodiments includes the first compound and/or the second compound, stable bonding with the second electron injection layer EIL2 may be achieved, and accordingly, the element stability may be improved, and electron injection properties may be improved. For example, because the atoms in the first compound and/or the second compound of the first electron injection layer EIL1 and the metal atoms of the second electron injection layer EIL2 make stable coordinate covalent bonds, suitable binding affinity may be obtained, and element stability may be improved. For example, at least a portion of the metal material of the second electron injection layer may make a coordinate covalent bond with the N atom of the first compound or the O atom of the second compound For example, the first electron injection layer EIL1 of one or more embodiments may include the first compound, and the coordinate covalent bond of "nitrogen atom-metal material-nitrogen atom" may be formed by the nitrogen atoms of a phenanthroline moiety included in the first compound. In some embodiments, the first electron injection layer EIL1 of one or more embodiments may include the second compound, and the coordinate covalent bond of "phosphorus atom-oxygen atom-metal material-oxygen atom-phosphorus atom" may be formed by phosphine oxide included in the second compound. Through the stable coordinate covalent bond between the nonmetal atom in the first electron injection layer EIL1 and the metal atom in the second electron injection layer EIL2, the migration and aggregation of the metal material included in the second electron injection layer EIL2 may be restrained, and element stability may be secured.

In the light emitting element ED of one or more embodiments, according to the stacking of the first electron injection layer EIL1 including an organic material on the electron transport layer ETL, light transmittance may be improved. The first electron injection layer EIL1 may be composed of a material having higher light transmittance than the second electron injection layer EIL2. In one or more embodiments, in the case of the double layer of the first electron injection layer EIL1 and the second electron injection layer EIL2, light transmittance may be higher than a case of forming a layer to a thickness of the sum of a thickness of the first electron injection layer EIL1 and a thickness of the second electron injection layer EIL2, by utilizing the metal material included in the second electron injection layer EIL2. The light transmittance of the double layer of the first electron injection layer EIL1 and the second electron injection layer EIL2 may be higher by about 1.5 times or more when compared to the light transmittance of the structure of a layer formed to a thickness of the sum of the thickness of the first electron injection layer EIL1 and the thickness of the second electron injection layer EIL2, by utilizing the metal material included in the second electron injection layer EIL2.

In the light emitting element ED of one or more embodiments, the thickness T1 of the first electron injection layer EIL1 may be about 10 nm or less, and the thickness T2 of the second electron injection layer EIL2 may be about 0.7 nm or more. In some embodiments, the thickness T1 of the first electron injection layer EIL1 and the thickness T2 of the second electron injection layer EIL2 may each independently be about 1 nm to about 5 nm. The sum of the thickness T1 of the first electron injection layer EIL1 and the thickness T2 of the second electron injection layer EIL2 may be about 2 nm to about 4 nm. In one or more embodiments, a ratio of the thickness T2 of the second electron injection layer EIL2 to the thickness T1 of the first electron injection layer EIL1 may be about 1 : 1 to about 5 : 1. For example, in some embodiments, the ratio of the thickness T2 of the second electron injection layer EIL2 to the thickness T1 of the first electron injection layer EIL1 may be about 1 : 1 to about 3 : 1. Each of the thickness T1 of the first electron injection layer EIL1 and the thickness T2 of the second electron injection layer EIL2 may be about 3% to about 7% of a thickness of the electron transport layer ETL. For example, in some embodiments, each of the thickness T1 of the first electron injection layer EIL1 and the thickness T2 of the second electron injection layer EIL2 may be about 5% of the thickness of the electron transport layer ETL. Because the thickness T1 of the first electron injection layer EIL1 and the thickness T2 of the second electron injection layer EIL2 have the above-described properties, the light emitting element ED according to one or more embodiments of the present disclosure may achieve satisfactory electron injection properties in the electron transport region ETR without increasing a driving voltage, and element reliability may be improved. In one or more embodiments, because the thickness T1 of the first electron injection layer EIL1 and the thickness T2 of the second electron injection layer EIL2 have the above-described properties, the first electron injection layer EIL1 may form a stable layer structure at the interface with the electron transport layer ETL, the second electron injection layer EIL2 may form a stable layer structure at the interface with the second electrode EL2, and electron injection and electron transfer properties in the electron transport region ETR may be improved. In some embodiments, when the thickness T1 of the first electron injection layer EIL1 or the thickness T2 of the second electron injection layer EIL2 is about 5 nm or more, the thickness of the electron transport region ETR may become relatively thick, emission efficiency, particularly, emission efficiency of blue light may be reduced, and element lifetime may be reduced.

In one or more embodiments, an energy level of a lowest unoccupied molecular orbital (LUMO) of the first electron injection layer EIL1 may be about -1.85 eV or less. The energy level of a LUMO is calculated from the reduction onset of the electric potential(V)-electric current(A) graph obtained through cyclic voltammetry (CV). The energy level of the LUMO of the first electron injection layer EIL1 may be lower than an energy level of a LUMO of the electron transport layer ETL. Accordingly, electron injection and electron transfer properties between the electron transport layer ETL and the first electron injection layer EIL1 may be improved. An energy level of a highest occupied molecular orbital (HOMO) of the first electron injection layer EIL1 may be about -5.60 eV or less. The energy level of a HOMO is calculated from the oxidation onset of the electric potential(V)-electric current(A) graph obtained through cyclic voltammetry (CV). Accordingly, the binding affinity of the first electron injection layer EIL1 and the second electron injection layer EIL2 may be suitably formed, and electron injection and electron transfer properties between the electron transport layer ETL and the first electron injection layer EIL1 may be improved.

The electron transport region ETR may be formed utilizing one or more suitable methods such as a vacuum deposition method, a spin coating method, a casting method, a Langmuir-Blodgett (LB) method, an inkjet printing method, a laser printing method, and/or a laser induced thermal imaging (LITI) method.

In one or more embodiments, the electron transport region ETR may include a compound represented by Formula ET-2 in addition to the first compound and/or the second compound, and the metal material.

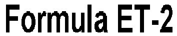

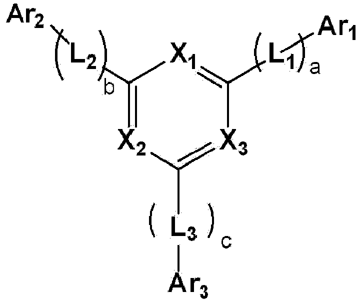

In Formula ET-2, at least one selected from among X₁ to X₃ may be N, and the remainder may be CRₐ. Rₐ may be hydrogen, deuterium, a substituted or unsubstituted alkyl of 1 to 20 carbon atoms, a substituted or unsubstituted aryl group of 6 to 30 ring-forming carbon atoms, or a substituted or unsubstituted heteroaryl group of 2 to 30 ring-forming carbon atoms. Ar₁ to Ar₃ may each independently be hydrogen, deuterium, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms.

In Formula ET-2, "a" to "c" may each independently be an integer of 0 to 10. In Formula ET-2, L₁ to L₃ may each independently be a direct linkage, a substituted or unsubstituted arylene group of 6 to 30 ring-forming carbon atoms, or a substituted or unsubstituted heteroarylene group of 2 to 30 ring-forming carbon atoms. In some embodiments, when "a" to "c" are integers of 2 or more, L₁ to L₃ may each independently be a substituted or unsubstituted arylene group of 6 to 30 ring-forming carbon atoms, or a substituted or unsubstituted heteroarylene group of 2 to 30 ring-forming carbon atoms.

In one or more embodiments, the electron transport region ETR may include an anthracene-based compound. However, embodiments of the present disclosure are not limited thereto, for example, in some embodiments, the electron transport region ETR may include, for example, at least one selected from among tris(8-hydroxyquinolinato)aluminium (Alqs), 1,3,5-tri[(3-pyridyl)-phen-3-yl]benzene, 2,4,6-tris(3'-(pyridin-3-yl)biphenyl-3-yl)-1,3,5-triazine, 2-(4-(N-phenylbenzimidazolyl-1-yl)phenyl)-9,10-dinaphthylanthracene, 1,3,5-tri(1-phenyl-1H-benzo[d]imidazol-2-yl)benzene (TPBi), 2,9-dimethyl-4,7-diphenyl-1,10-phenanthroline (BCP), 4,7-diphenyl-1,10-phenanthroline (Bphen), 3-(biphenyl-4-yl)-4-phenyl-5-tert-butylphenyl-1,2,4-triazole (TAZ), 4-(naphthalen-1-yl)-3,5-diphenyl-4H-1,2,4-triazole (NTAZ), 2-(biphenyl-4-yl)-5-(4-tert-butylphenyl)-1,3,4-oxadiazole (tBu-PBD), bis(2-methyl-8-quinolinolato-N1,O8)-(1,1'-biphenyl-4-olato)aluminium (BAlq), berylliumbis(benzoquinolin-10-olate (Bebq₂), 9,10-di(naphthalene-2-yl)anthracene (ADN), 1,3-bis[3,5-di(pyridin-3-yl)phenyl]benzene (BmPyPhB), and one or more mixtures thereof, without limitation.

In one or more embodiments, the electron transport region ETR may include at least one selected from among Compounds ET1 to ET36.

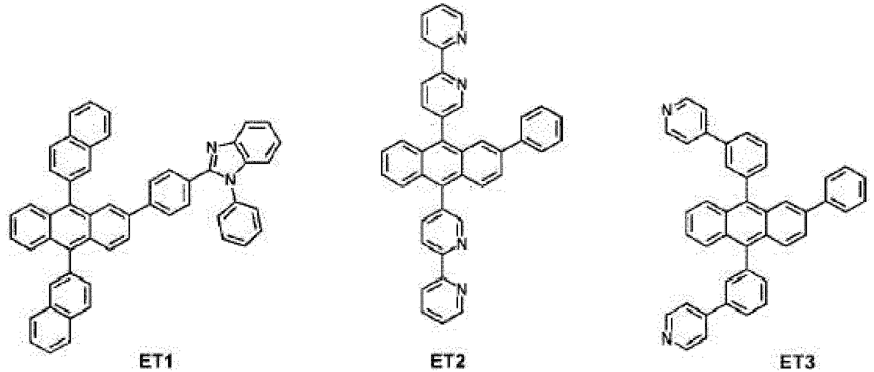

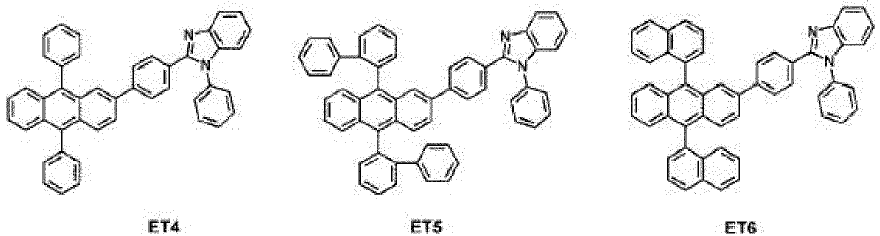

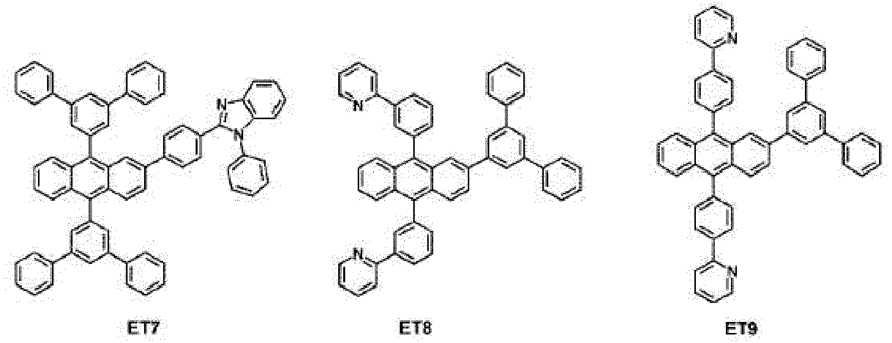

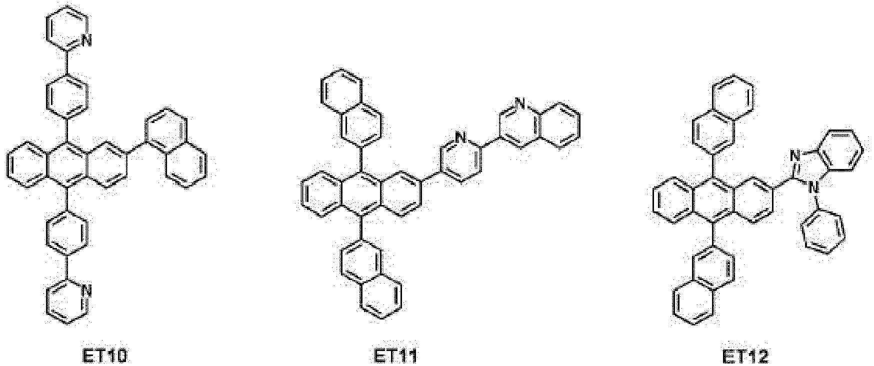

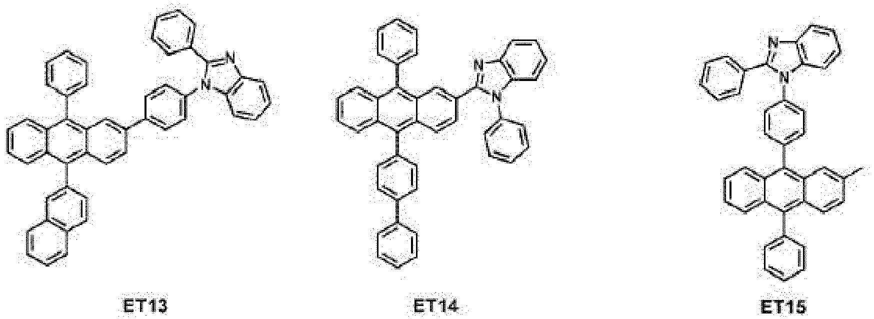

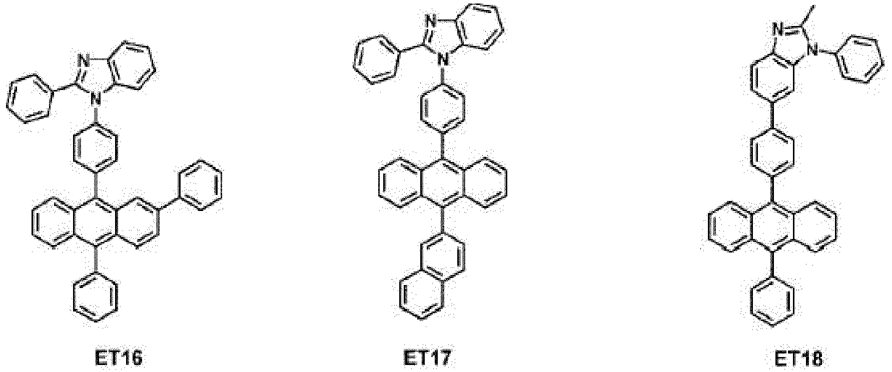

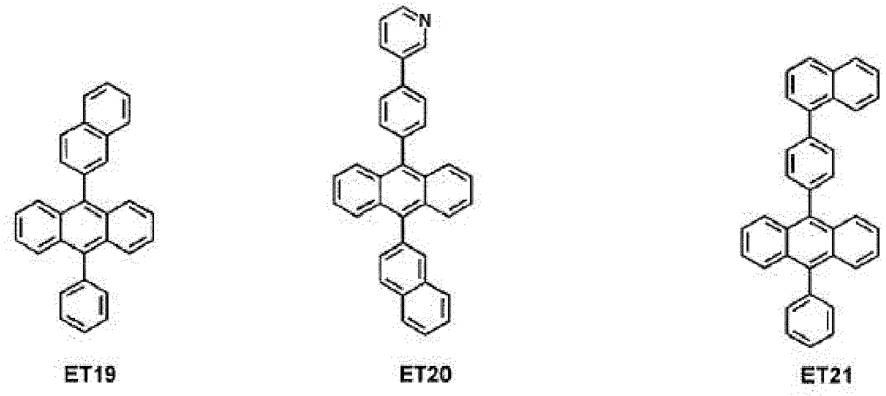

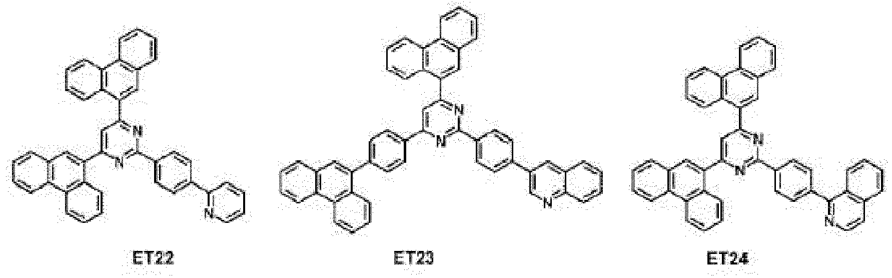

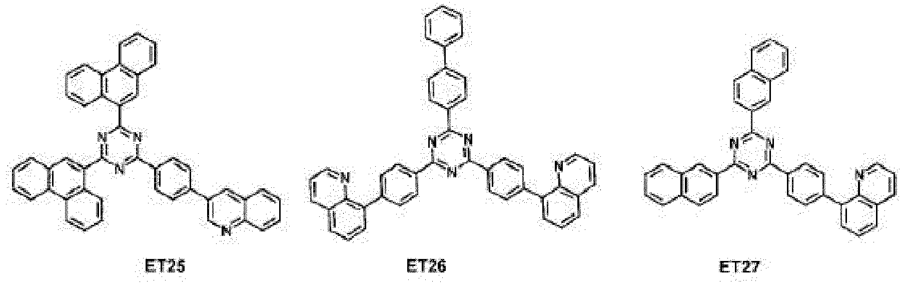

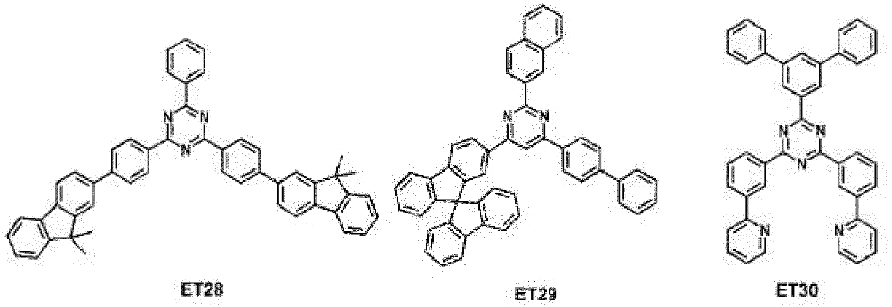

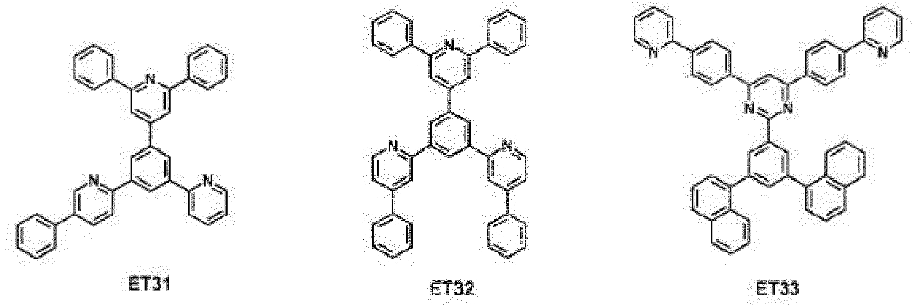

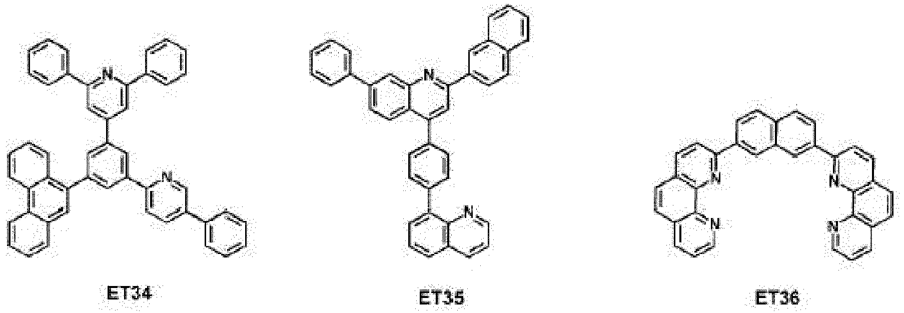

In some embodiments, the electron transport region ETR may include a metal halide such as LiF, NaCl, CsF, RbCl, Rbl, Cui and/or KI, a metal of lanthanoids (e.g., a lanthanide metal) such as Yb, or a co-depositing material of the metal halide and the metal of lanthanoids. For example, in some embodiments, the electron transport region ETR may include KI:Yb, RbI:Yb, LiF:Yb, *etc.,* as a co-depositing material. In some embodiments, the electron transport region ETR may utilize a metal oxide such as Li₂O and/or BaO, or 8-hydroxy-lithium quinolate (Liq). However, embodiments of the present disclosure are not limited thereto. In some embodiments, the electron transport region ETR may be formed utilizing a mixture material of an electron transport material and an insulating organo metal salt. The organo metal salt may be a material having an energy band gap of about 4 eV or more. For example, the organo metal salt may include, for example, one or more of metal acetates, metal benzoates, metal acetoacetates, metal acetylacetonates, or metal stearates.

In one or more embodiments, the electron transport region ETR may include at least one of 2,9-dimethyl-4,7-diphenyl-1,10-phenanthroline (BCP), diphenyl(4-(triphenylsilyl)phenyl)phosphine oxide (TSPO1), or 4,7-diphenyl-1,10-phenanthroline (Bphen) in addition to the aforementioned materials. However, embodiments of the present disclosure are not limited thereto.

The electron transport region ETR may include one or more of the above-described compounds of the electron transport region in at least one selected from among a first electron injection layer EIL1, a second electron injection layer EIL2, an electron transport layer ETL, and a hole blocking layer HBL. For example, in some embodiments, the electron transport layer ETL may include the above-described metal, metal oxide, Liq, or organometal salt. In some embodiments, the electron transport layer ETL may include the compound represented by Formula ET-2 or an anthracene compound, and at the same time, the metal, metal oxide, or Liq.

The second electrode EL2 is provided on the electron transport region ETR. The second electrode EL2 may be a common electrode. The second electrode EL2 may be a cathode or an anode, but embodiments of the present disclosure are not limited thereto. For example, when the first electrode EL1 is an anode, the second electrode EL2 may be a cathode, and when the first electrode EL1 is a cathode, the second electrode EL2 may be an anode.

The second electrode EL2 may be a transmissive electrode, a transflective electrode, or a reflective electrode. When the second electrode EL2 is the transmissive electrode, the second electrode EL2 may be formed of a transparent metal oxide, for example, indium tin oxide (ITO), indium zinc oxide (IZO), zinc oxide (ZnO), indium tin zinc oxide (ITZO), *etc.*

When the second electrode EL2 is the transflective electrode or the reflective electrode, the second electrode EL2 may include Ag, Mg, Cu, Al, Pt, Pd, Au, Ni, Nd, Ir, Cr, Li, Ca, LiF/Ca, LiF/Al, Mo, Ti, Yb, W, or one or more compounds thereof, or one or more mixtures thereof (e.g., AgMg, AgYb, or MgAg). In some embodiments, the second electrode EL2 may have a multilayer structure including a reflective film or a transflective film formed of one or more of the above-described materials, and a transparent conductive film formed of ITO, IZO, ZnO, ITZO, *etc.* For example, the second electrode EL2 may include one of the above-described metal materials, one or more combinations of at least two metal materials of the above-described metal materials, one or more oxides of the above-described metal materials, and/or the like.

In some embodiments, the second electrode EL2 may be connected with an auxiliary electrode. When the second electrode EL2 is connected with the auxiliary electrode, the resistance of the second electrode EL2 may be decreased.

In one or more embodiments, a capping layer CPL may further be disposed on the second electrode EL2 of the light emitting element ED of one or more embodiments. The capping layer CPL may include a multilayer or a single layer.

In one or more embodiments, the capping layer CPL may be an organic layer and/or an inorganic layer. For example, in some embodiments, when the capping layer CPL contains an inorganic material, the inorganic material may include an alkali metal compound (*e.g*., LiF), an alkaline earth metal compound (*e.g*., MgF₂), SiON, SiNₓ, SiO_{y}, *etc.*

For example, in some embodiments, when the capping layer CPL includes an organic material, the organic material may include one or more of 2,2'-dimethyl-N,N'-di-[(1-naphthyl)-N,N'-diphenyl]-1,1'-biphenyl-4,4'-diamine (α-NPD), NPB, TPD, m-MTDATA, Alqs, CuPc, N4,N4,N4',N4'-tetra(biphenyl-4-yl)biphenyl-4,4'-diamine (TPD15), 4,4',4"-tris(carbazol-9-yl)triphenylamine (TCTA), etc., or an epoxy resin, or acrylate such as methacrylate. However, embodiments of the present disclosure are not limited thereto, for example, the capping layer CPL may include at least one selected from among Compounds P1 to P5:

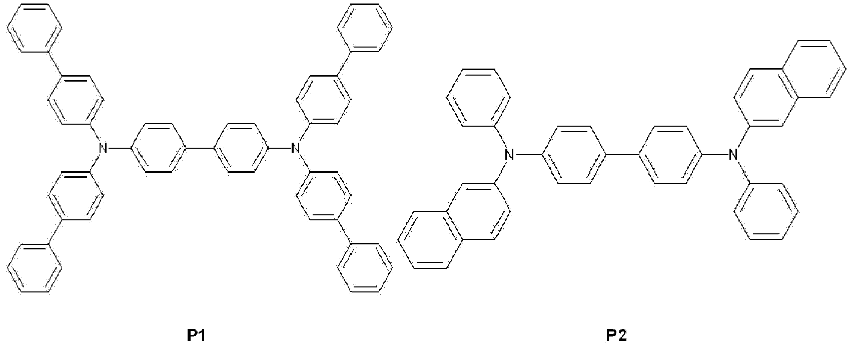

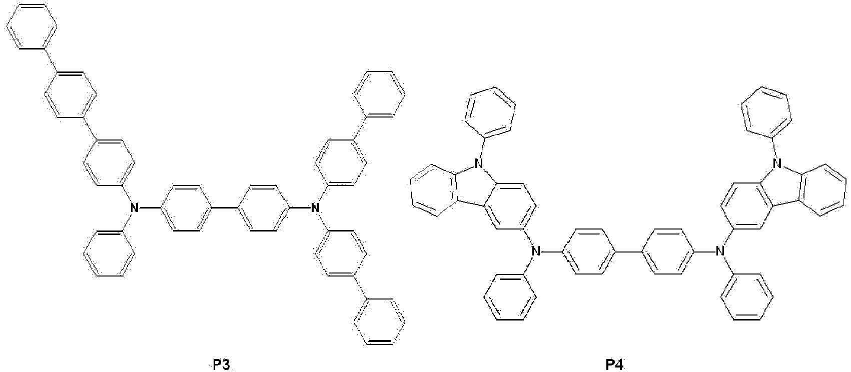

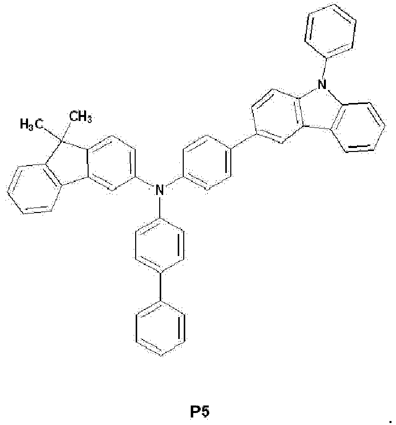

In some embodiments, the refractive index of the capping layer CPL may be about 1.6 or more. For example, in one or more embodiments, the refractive index of the capping layer CPL may be about 1.6 or more with respect to light in a wavelength range of about 550 nm to about 660 nm.

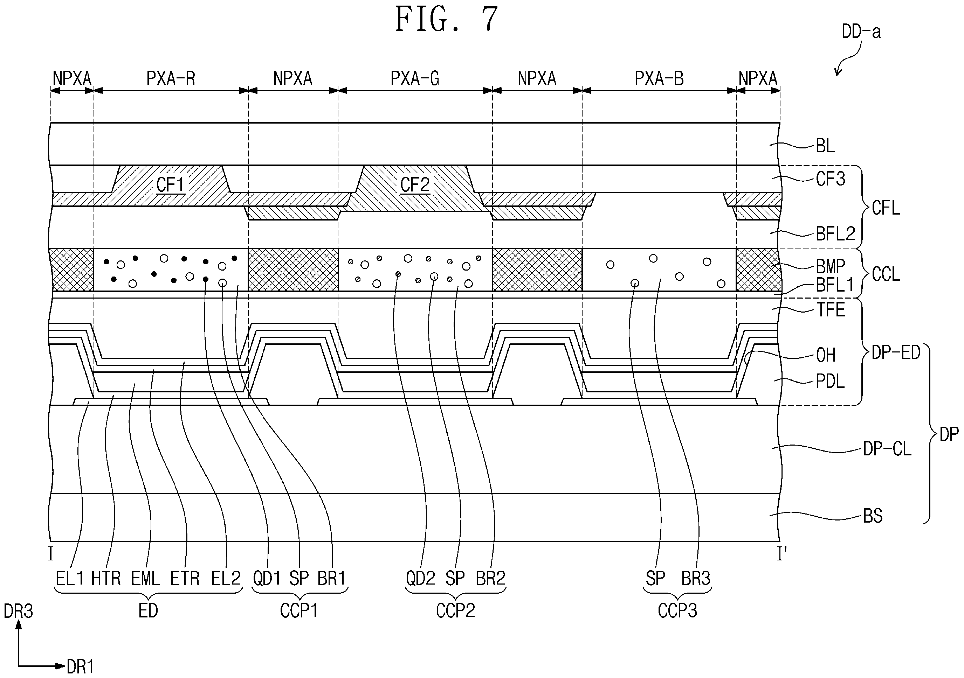

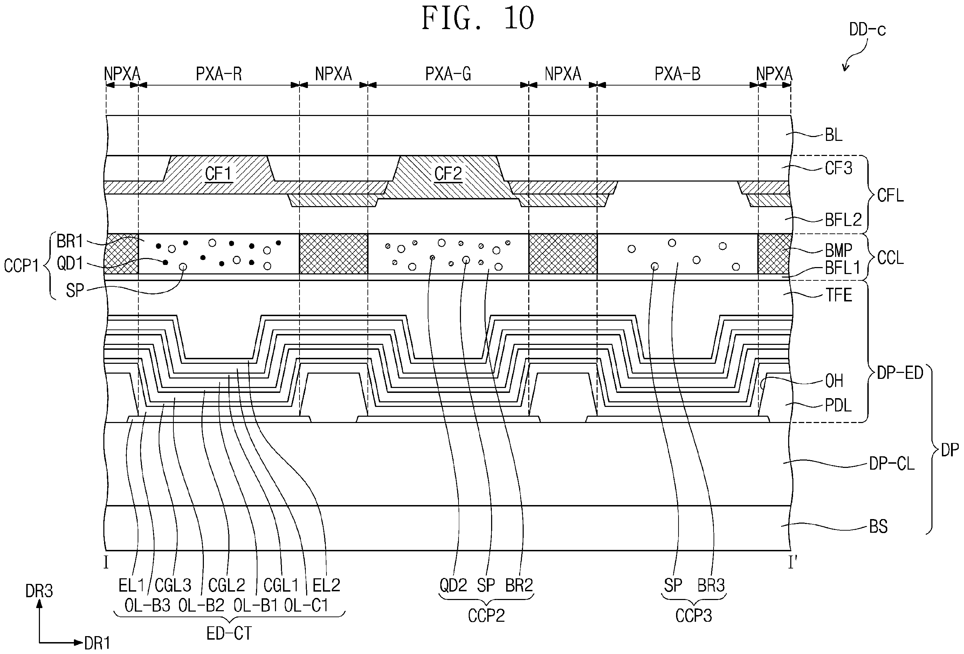

Each of FIGs. 7 to 10 is a cross-sectional view of a display apparatus according to one or more embodiments of the present disclosure. Hereinafter, in describing the display apparatuses of embodiments with reference to FIGs. 7 to 10, the duplicated features which have been described in FIGs. 1 to 6 are not described again, but their differences will be mainly described.

Referring to FIG. 7, the display apparatus DD-a according to one or more embodiments may include a display panel DP including a display device layer DP-ED, a light control layer CCL on the display panel DP, and a color filter layer CFL. In one or more embodiments illustrated in FIG. 7, the display panel DP may include a base layer BS, a circuit layer DP-CL provided on the base layer BS, and the display device layer DP-ED, and the display device layer DP-ED may include a light emitting device ED.

The light emitting device ED includes a first electrode EL1, a hole transport region HTR on the first electrode EL1, an emission layer EML on the hole transport region HTR, an electron transport region ETR on the emission layer EML, and a second electrode EL2 on the electron transport region ETR. In one or more embodiments, the structure of each of the light emitting elements of FIGs. 3 to 6 as described above may be equally applied to the structure of the light emitting device ED illustrated in FIG. 7.

Referring to FIG. 7, the emission layer EML may be disposed in an opening OH defined in a pixel defining film PDL. For example, the emission layer EML which is divided by the pixel defining film PDL and provided corresponding to each light emitting regions PXA-R, PXA-G, and PXA-B may be to emit light in substantially the same wavelength range. In the display apparatus DD-a of one or more embodiments, the emission layer EML may be to emit blue light. In some embodiments, the emission layer EML may be provided as a common layer in the entire light emitting regions PXA-R, PXA-G, and PXA-B.

The light control layer CCL may be disposed on the display panel DP. The light control layer CCL may include a light conversion body. The light conversion body may be a quantum dot, a phosphor, and/or the like. The light conversion body may be to emit provided light by converting the wavelength thereof. For example, the light control layer CCL may be a layer containing the quantum dot or a layer containing the phosphor.

The light control layer CCL may include a plurality of light control parts CCP1, CCP2, and CCP3. The light control parts CCP1, CCP2, and CCP3 may be spaced apart from each other.

Referring to FIG. 7, divided patterns BMP may be disposed between the light control parts CCP1, CCP2, and CCP3 which are spaced apart from each other, but embodiments of the present disclosure are not limited thereto. FIG. 7 illustrates that the divided patterns BMP do not overlap the light control parts CCP1, CCP2, and CCP3, but, in some embodiments, at least a portion of the edges of the light control parts CCP1, CCP2, and CCP3 may overlap the divided patterns BMP.

The light control layer CCL may include a first light control part CCP1 containing a first quantum dot QD1 which converts first color light provided from the light emitting device ED into second color light, a second light control part CCP2 containing a second quantum dot QD2 which converts the first color light into third color light, and a third light control part CCP3 which transmits the first color light.

In one or more embodiments, the first light control part CCP1 may provide red light that is the second color light, and the second light control part CCP2 may provide green light that is the third color light. The third light control part CCP3 may provide blue light by transmitting the blue light that is the first color light provided from the light emitting device ED. For example, in some embodiments, the first quantum dot QD1 may be a red quantum dot to emit red light, and the second quantum dot QD2 may be a green quantum dot to emit green light. The same as described above related to quantum dots may be applied with respect to the quantum dots QD1 and QD2.

In some embodiments, the light control layer CCL may further include a scatterer SP. The first light control part CCP1 may include the first quantum dot QD1 and the scatterer SP, the second light control part CCP2 may include the second quantum dot QD2 and the scatterer SP, and the third light control part CCP3 may not include (*e.g*., may exclude) any quantum dot but include the scatterer SP.

The scatterer SP may be inorganic particles. For example, the scatterer SP may include at least one of TiO₂, ZnO, Al₂O₃, SiO₂, or hollow sphere silica. In one or more embodiments, the scatterer SP may include any one selected from among TiO₂, ZnO, Al₂O₃, SiO₂, and hollow sphere silica, or may be a mixture of at least two materials selected from among TiO₂, ZnO, Al₂O₃, SiO₂, and hollow sphere silica.

The first light control part CCP1, the second light control part CCP2, and the third light control part CCP3 may respectively include base resins BR1, BR2, and BR3 in which the quantum dots QD1 and QD2 and the scatterer SP are dispersed. In one or more embodiments, the first light control part CCP1 may include the first quantum dot QD1 and the scatterer SP dispersed in a first base resin BR1, the second light control part CCP2 may include the second quantum dot QD2 and the scatterer SP dispersed in a second base resin BR2, and the third light control part CCP3 may include the scatterer SP dispersed in a third base resin BR3.

The base resins BR1, BR2, and BR3 are media in which the quantum dots QD1 and QD2 and the scatterer SP are dispersed, and may be formed of one or more suitable resin compositions, which may be generally referred to as a binder. For example, the base resins BR1, BR2, and BR3 may each independently be one or more of acrylic-based resins, urethane-based resins, silicone-based resins, epoxy-based resins, *etc.* The base resins BR1, BR2, and BR3 may be transparent resins. In some embodiments, the first base resin BR1, the second base resin BR2, and the third base resin BR3 may be the same as or different from each other.

In one or more embodiments, the light control layer CCL may include a barrier layer BFL1. The barrier layer BFL1 may serve to prevent or reduce the penetration of moisture and/or oxygen (hereinafter, referred to as 'moisture/oxygen'). The barrier layer BFL1 may block or reduce the light control parts CCP1, CCP2, and CCP3 from being exposed to moisture/oxygen. In some embodiments, the barrier layer BFL1 may cover the light control parts CCP1, CCP2, and CCP3. In some embodiments, a barrier layer BFL2 may be provided between the light control parts CCP1, CCP2, and CCP3 and the color filter layer CFL.

The barrier layers BFL1 and BFL2 may include at least one inorganic layer. For example, the barrier layers BFL1 and BFL2 may each independently include an inorganic material. For example, the barrier layers BFL1 and BFL2 may each independently include one or more selected from among a silicon nitride, an aluminium nitride, a zirconium nitride, a titanium nitride, a hafnium nitride, a tantalum nitride, a silicon oxide, an aluminium oxide, a titanium oxide, a tin oxide, a cerium oxide, a silicon oxynitride, a metal thin film which secures a transmittance, *etc.* In some embodiments, the barrier layers BFL1 and BFL2 may each further include an organic film. The barrier layers BFL1 and BFL2 may each independently be formed of a single layer or a plurality of layers.

In the display apparatus DD-a of one or more embodiments, the color filter layer CFL may be disposed on the light control layer CCL. For example, in some embodiments, the color filter layer CFL may be directly disposed on the light control layer CCL. In these embodiments, the barrier layer BFL2 may not be provided.

The color filter layer CFL may include color filters CF1, CF2, and CF3. The color filter layer CFL may include a first filter CF1 configured to transmit the second color light, a second filter CF2 configured to transmit the third color light, and a third filter CF3 configured to transmit the first color light. For example, in some embodiments, the first filter CF1 may be a red filter, the second filter CF2 may be a green filter, and the third filter CF3 may be a blue filter. The filters CF1, CF2, and CF3 each may include a polymeric photosensitive resin and a pigment and/or dye. The first filter CF1 may include a red pigment and/or dye, the second filter CF2 may include a green pigment and/or dye, and the third filter CF3 may include a blue pigment and/or dye.

However, embodiments of the present disclosure are not limited thereto, and the third filter CF3 may not include (*e.g.*, may exclude) any pigment and/or dye. The third filter CF3 may include a polymeric photosensitive resin and may not include (*e.g*., may exclude) any pigment and/or dye. The third filter CF3 may be transparent. The third filter CF3 may be formed of a transparent photosensitive resin.

Furthermore, in one or more embodiments, the first filter CF1 and the second filter CF2 may be a yellow filter. The first filter CF1 and the second filter CF2 may not be separated but be provided as one filter.

In one or more embodiments, the color filter layer CFL may further include a light shielding part. The light shielding part may be a black matrix. The light shielding part may include an organic light shielding material and/or an inorganic light shielding material containing a black pigment and/or dye. The light shielding part may prevent or reduce light leakage, and may separate boundaries between the adjacent filters CF1, CF2, and CF3.

The first to third filters CF1, CF2, and CF3 may be disposed corresponding to the red light emitting region PXA-R, the green light emitting region PXA-G, and the blue light emitting region PXA-B, respectively.

A base substrate BL may be disposed on the color filter layer CFL. The base substrate BL may be a member which provides a base surface on which the color filter layer CFL, the light control layer CCL, and/or the like are disposed. The base substrate BL may be a glass substrate, a metal substrate, a plastic substrate, *etc.* However, embodiments of the present disclosure are not limited thereto, and the base substrate BL may be an inorganic layer, an organic layer, or a composite material layer. In some embodiments, the base substrate BL may not be provided.

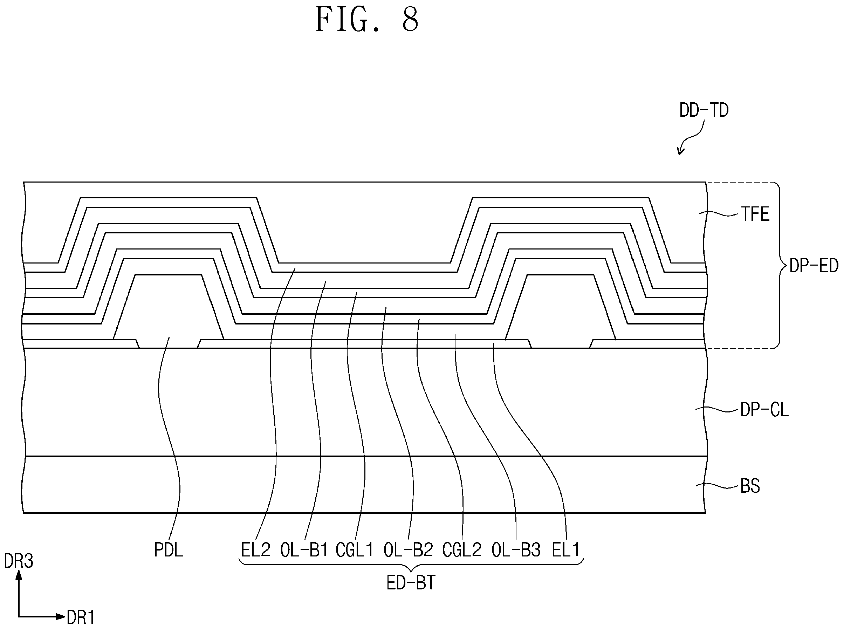

FIG. 8 is a cross-sectional view illustrating a portion of a display apparatus according to one or more embodiments. In the display apparatus DD-TD of one or more embodiments, a light emitting device ED-BT may include a plurality of light emitting structures OL-B1, OL-B2, and OL-B3. The light emitting device ED-BT may include a first electrode EL1 and a second electrode EL2 which face each other, and the plurality of light emitting structures OL-B1, OL-B2, and OL-B3 sequentially stacked in a thickness direction between the first electrode EL1 and the second electrode EL2. The light emitting structures OL-B1, OL-B2, and OL-B3 each may include an emission layer EML (FIG. 7) and a hole transport region HTR and an electron transport region ETR disposed with the emission layer EML (FIG. 7) therebetween.

For example, in some embodiments, the light emitting device ED-BT included in the display apparatus DD-TD of one or more embodiments may be a light emitting device having a tandem structure and including a plurality of emission layers.

In one or more embodiments illustrated in FIG. 8, all light beams respectively emitted from the light emitting structures OL-B1, OL-B2, and OL-B3 may be blue light. However, embodiments of the present disclosure are not limited thereto, and the light beams respectively emitted from the light emitting structures OL-B1, OL-B2, and OL-B3 may have wavelength ranges different from each other. For example, in some embodiments, the light emitting device ED-BT including the plurality of light emitting structures OL-B1, OL-B2, and OL-B3 which emit light beams having wavelength ranges different from each other may be to emit white light (*e.g*., combined white light).

Charge generation layers CGL1 and CGL2 may be respectively disposed between two of the neighboring light emitting structures OL-B1, OL-B2, and OL-B3. The charge generation layers CGL1 and CGL2 may include a p-type or kind charge (*e.g*., P-charge) generation layer and/or an n-type or kind charge (*e.g*., N-charge) generation layer.

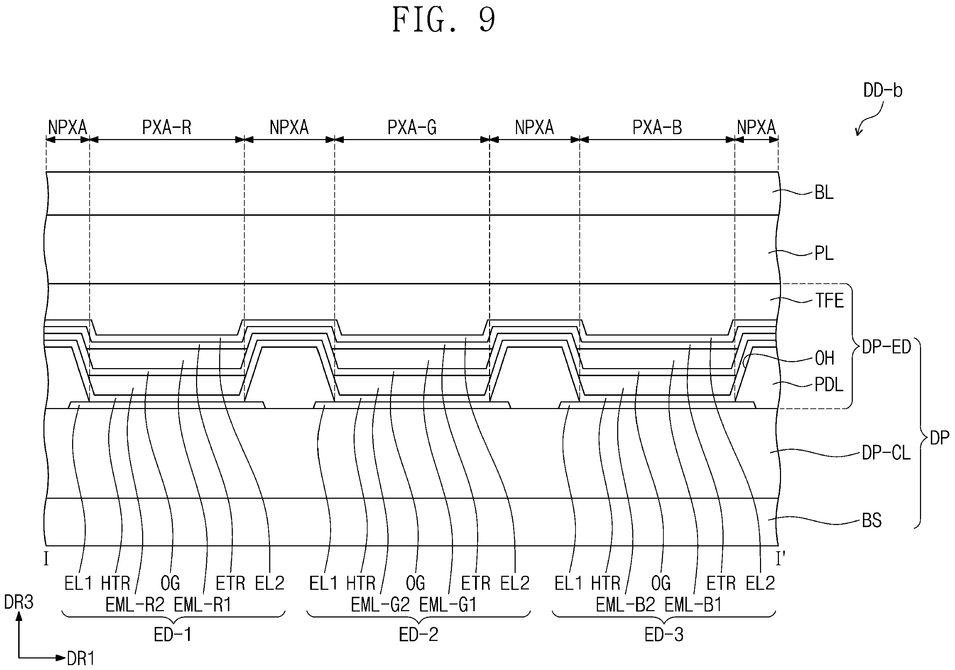

Referring to FIG. 9, a display apparatus DD-b according to one or more embodiments may include light emitting devices ED-1, ED-2, and ED-3 in which two emission layers are stacked. Compared with the display apparatus DD illustrated in FIG. 2, the display apparatus DD-b illustrated in FIG. 9 has a difference in that first to third light emitting devices ED-1, ED-2, and ED-3 each include two emission layers stacked in a thickness direction. In each of the first to third light emitting devices ED-1, ED-2, and ED-3, the two emission layers may be to emit light in substantially the same wavelength region.

In one or more embodiments, the first light emitting device ED-1 may include a first red emission layer EML-R1 and a second red emission layer EML-R2. The second light emitting device ED-2 may include a first green emission layer EML-G1 and a second green emission layer EML-G2. In addition, the third light emitting device ED-3 may include a first blue emission layer EML-B1 and a second blue emission layer EML-B2. An emission auxiliary part OG may be disposed between the first red emission layer EML-R1 and the second red emission layer EML-R2, between the first green emission layer EML-G1 and the second green emission layer EML-G2, and between the first blue emission layer EML-B1 and the second blue emission layer EML-B2.

The emission auxiliary part OG may include a single layer or a multilayer. The emission auxiliary part OG may include a charge generation layer. In one or more embodiments, the emission auxiliary part OG may include an electron transport region, a charge generation layer, and a hole transport region that are sequentially stacked (*e.g*., in the stated order). The emission auxiliary part OG may be provided as a common layer in the whole of the first to third light emitting devices ED-1, ED-2, and ED-3. However, embodiments of the present disclosure are not limited thereto, and the emission auxiliary part OG may be provided by being patterned within the openings OH defined in the pixel defining film PDL.

The first red emission layer EML-R1, the first green emission layer EML-G1, and the first blue emission layer EML-B1 may each be disposed between the hole transport region HTR and the emission auxiliary part OG. The second red emission layer EML-R2, the second green emission layer EML-G2, and the second blue emission layer EML-B2 may each be disposed between the emission auxiliary part OG and the electron transport region ETR.

For example, in one or more embodiments, the first light emitting device ED-1 may include a first electrode EL1, a hole transport region HTR, a second red emission layer EML-R2, an emission auxiliary part OG, a first red emission layer EML-R1, an electron transport region ETR, and a second electrode EL2 that are sequentially stacked (*e.g*., in the stated order). The second light emitting device ED-2 may include a first electrode EL1, a hole transport region HTR, a second green emission layer EML-G2, an emission auxiliary part OG, a first green emission layer EML-G1, an electron transport region ETR, and a second electrode EL2 that are sequentially stacked (*e.g.*, in the stated order). The third light emitting device ED-3 may include a first electrode EL1, a hole transport region HTR, a second blue emission layer EML-B2, an emission auxiliary part OG, a first blue emission layer EML-B1, an electron transport region ETR, and a second electrode EL2 that are sequentially stacked (*e.g.*, in the stated order).

In some embodiments, an optical auxiliary layer PL may be disposed on the display device layer DP-ED. The optical auxiliary layer PL may include a polarizing layer. The optical auxiliary layer PL may be disposed on the display panel DP and control reflected light in the display panel DP due to external light. In some embodiments, the optical auxiliary layer PL in the display apparatus may not be provided.

Unlike FIG. 8 and FIG. 9, FIG. 10 illustrates that a display apparatus DD-c may include four light emitting structures OL-B1, OL-B2, OL-B3, and OL-C1. A light emitting device ED-CT may include a first electrode EL1 and a second electrode EL2 which face each other, and first to fourth light emitting structures OL-B1, OL-B2, OL-B3, and OL-C1 that are stacked in a thickness direction between the first electrode EL1 and the second electrode EL2. Charge generation layers CGL1, CGL2, and CGL3 may be disposed between the first to fourth light emitting structures OL-B1, OL-B2, OL-B3, and OL-C1. Among the four light emitting structures, the first to third light emitting structures OL-B1, OL-B2, and OL-B3 may be to emit blue light, and the fourth light emitting structure OL-C1 may be to emit green light. However, embodiments of the present disclosure are not limited thereto, and the first to fourth light emitting structures OL-B1, OL-B2, OL-B3, and OL-C1 may be to emit light beams in different wavelength regions.

The charge generation layers CGL1, CGL2, and CGL3 disposed between adjacent light emitting structures OL-B1, OL-B2, OL-B3, and OL-C1 may include a p-type or kind charge (*e.g*., P-charge) generation layer and/or an n-type or kind charge (*e.g*., N-charge) generation layer.

In one or more embodiments, the electronic apparatus may include a display apparatus including a plurality of light emitting devices, and a control part which controls the display apparatus. The electronic apparatus of one or more embodiments may be a device that is activated according to an electrical signal. The electronic apparatus may include display apparatuses of one or more suitable embodiments. For example, the electronic apparatus may include not only large-sized electronic apparatuses such as a television set, a monitor, or an outdoor billboard but also include small- and medium-sized electronic apparatuses such as a personal computer, a laptop computer, a personal digital terminal, a display apparatus for a vehicle, a game console, a portable electronic device, or a camera.

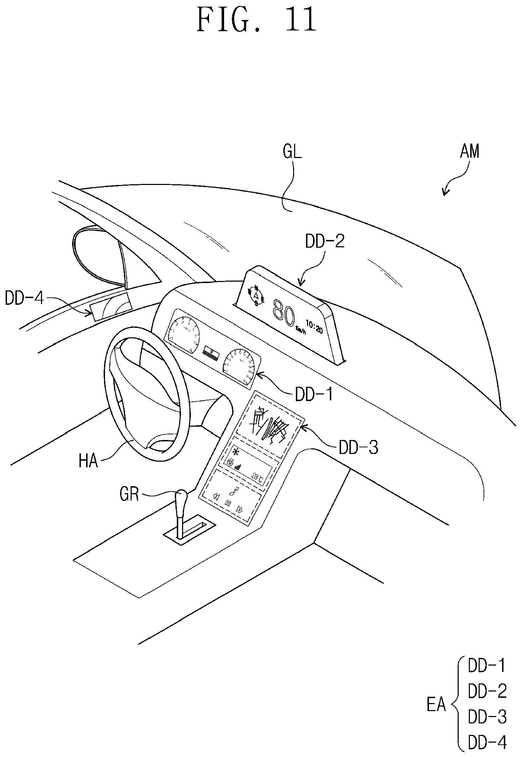

FIG. 11 is a view illustrating a vehicle AM in which first to fourth display apparatuses DD-1, DD-2, DD-3, and DD-4 are disposed. At least one selected from among the first to fourth display apparatuses DD-1, DD-2, DD-3, and DD-4 may include substantially the same configuration as the display apparatuses DD, DD-TD, DD-a, DD-b, and/or DD-c as described with reference to FIGs. 1, and 2, and 7 to 10.

FIG. 11 illustrates a vehicle AM, but this is a mere example. The first to fourth display apparatuses DD-1, DD-2, DD-3, and DD-4 may be disposed in another transportation apparatus such as bicycles, motorcycles, trains, ships, and/or airplanes. In some embodiments, at least one selected from among the first to fourth display apparatuses DD-1, DD-2, DD-3, and DD-4 including substantially the same configuration as the display apparatuses DD, DD-TD, DD-a, DD-b, and/or DD-c of an embodiment may be employed in a personal computer, a laptop computer, a personal digital terminal, a game console, a portable electronic device, a television, a monitor, an outdoor billboard, and/or the like. These are merely provided as embodiments, and thus may be employed in other electronic apparatuses unless departing from the present disclosure.

In one or more embodiments, at least one selected from among the first to fourth display apparatuses DD-1, DD-2, DD-3, and DD-4 may include the light emitting element ED of one or more embodiments as described with reference to FIGs. 3 to 6.

The first to fourth display devices DD-1, DD-2, DD-3 and DD-4 may each independently include multiple light emitting elements ED, and each of the light emitting elements ED may include a first electrode EL1, a hole transport region HTR on the first electrode EL1, an emission layer EML on the hole transport region HTR, an electron transport region ETR on the emission layer EML and a second electrode EL2 on the electron transport region ETR. In one or more embodiments, the electron transport region ETR may include a first electron injection layer EIL1 and a second electron injection layer EIL2. Accordingly, the display device of one or more embodiments may show improved image quality.

Referring to FIG. 11, the vehicle AM may include a steering wheel HA and a gear GR for driving the vehicle AM. In addition, the vehicle AM may include a front window GL disposed so as to face a driver.

A first display apparatus DD-1 may be disposed in a first region overlapping the steering wheel HA. For example, the first display apparatus DD-1 may be a digital cluster which displays first information of the vehicle AM. The first information may include a first scale which indicates a driving speed of the vehicle AM, a second scale which indicates an engine speed (that is, revolutions per minute (RPM)), an image which indicates a fuel state, *etc.* The first scale and the second scale may be indicated as a digital image.

A second display apparatus DD-2 may be disposed in a second region facing a driver seat and overlapping the front window GL. The driver seat may be a seat in which the steering wheel HA faces. For example, the second display apparatus DD-2 may be a head up display (HUD) which displays second information of the vehicle AM. The second display apparatus DD-2 may be optically transparent. The second information may include digital numbers which indicate a driving speed, and may further include information such as the current time. In some embodiments, the second information of the second display apparatus DD-2 may be projected to the front window GL to be displayed.

A third display apparatus DD-3 may be disposed in a third region adjacent to the gear GR. For example, the third display apparatus DD-3 may be disposed between the driver seat and a passenger seat and may be a center information display (CID) of the vehicle for displaying third information. The passenger seat may be a seat spaced apart from the driver seat with the gear GR disposed therebetween. The third information may include information about traffic (*e.g*., navigation information), playing music or radio or a video (or an image), temperatures inside the vehicle AM, *etc.*

A fourth display apparatus DD-4 may be spaced apart from the steering wheel HA and the gear GR, and may be disposed in a fourth region adjacent to a side of the vehicle AM. For example, the fourth display apparatus DD-4 may be a digital side-view mirror which displays fourth information. The fourth display apparatus DD-4 may display an image outside the vehicle AM taken by a camera module disposed outside the vehicle AM. The fourth information may include an image outside the vehicle AM.

The above-described first to fourth information may be examples, and the first to fourth display apparatuses DD-1, DD-2, DD-3, and DD-4 may further display information about the inside and outside of the vehicle AM. The first to fourth information may include different information. However, embodiments of the present disclosure are not limited thereto, for example, in some embodiments, a part of the first to fourth information may include the same information as one another.

Hereinafter, referring to embodiments and comparative embodiments, the light emitting elements according to one or more embodiments of the present disclosure will be explained in particular. In addition, the embodiment below is an illustration to assist the understanding of the present disclosure, but the scope of the present disclosure is not limited thereto.

### Examples

### 1. Manufacture of light emitting elements

In Example 1 to Example 8, and Comparative Example 2 to Comparative Example 5, light emitting elements each having the structure of FIG. 4 were manufactured. Example 1 to Example 8 correspond to light emitting elements manufactured by utilizing the Example Compounds as the materials of the first electron injection layer EIL1, and ytterbium (Yb) as the material of the second electron injection layer EIL2. For example, Example 1 to Example 5 each utilized the first compound of Compound A6, and Example 6 to Example 8 each utilized the second compound of Compound B1, as the materials of the first electron injection layer EIL1. In Comparative Example 1, a light emitting element of a structure in which the electron transport region ETR did not include the first electron injection layer EIL1, was manufactured. For example, in Comparative Example 1, a light emitting element of a structure in which the second electron injection layer EIL2 was disposed directly on the electron transport layer ETL in the electron transport region ETR, was manufactured. In Comparative Example 1, all components were the same as Example 1 to Example 8 except for the inclusion of the first electron injection layer EIL1 or not, and the numerical value of the thickness T2 of the second electron injection layer EIL2. In Comparative Example 2 to Comparative Example 5, all components were the same as Example 1 to Example 8 except for the material of the first electron injection layer EIL1, the numerical values of the thickness T1 of the first electron injection layer EIL1 and the thickness T2 of the second electron injection layer EIL2. The material of the first electron injection layer EIL1, the thickness T1 of the first electron injection layer EIL1 and the thickness T2 of the second electron injection layer EIL2 of each of Example 1 to Example 8 and Comparative Example 1 to Comparative Example 5 are shown in Table 1.

### Compounds in the Examples and Comparative Examples

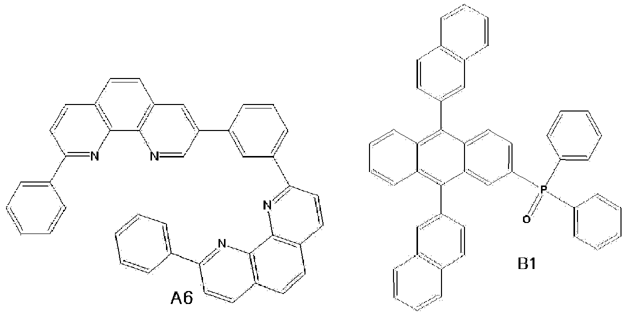

**Table 1**

| | Material included in first electron injection layer (EIL1) | Thickness (T1) of first electron injection layer (EIL1) | Thickness (T2) of second electron injection layer (EIL2) |
|---|---|---|---|
| Example 1 | Compound A6 | 1 nm | 1 nm |
| Example 2 | Compound A6 | 2 nm | 1 nm |
| Example 3 | Compound A6 | 3 nm | 1 nm |
| Example 4 | Compound A6 | 1 nm | 2 nm |
| Example 5 | Compound A6 | 2 nm | 2 nm |
| Example 6 | Compound B1 | 1 nm | 1 nm |
| Example 7 | Compound B1 | 2 nm | 1 nm |
| Example 8 | Compound B1 | 1 nm | 2 nm |
| Comparativ e Example 1 | - | - | 1.3 nm |
| Comparativ e Example 2 | Compound A6 | 7 nm | 1 nm |
| Comparativ e Example 3 | Compound A6 | 3 nm | 0.5 nm |
| Comparativ e Example 4 | Compound B1 | 10 nm | 0.5 nm |
| Comparativ e Example 5 | Zinc oxide (ZnO) | 1 nm | 1 nm |

Referring to Table 1, the first electron injection layers EIL1 of Example 1 to Example 5 each include the first compound, and the first injection layers EIL1 of Example 6 to Example 8 each include the second compound. In addition, the thicknesses T1 of the first electron injection layers EIL1 and the thicknesses T2 of the second electron injection layers EIL2 of Example 1 to Example 8 each correspond to about 1 nm to about 5 nm. In contrast, Comparative Example 1 does not include the first electron injection layer EIL1, and Comparative Example 2 and Comparative Example 3 each include the first compound, but the thickness of the first electron injection layer EIL1 has a value greater than about 5 nm or the thickness of the second electron injection layer EIL2 has a value less than about 1 nm. Comparative Example 4 includes the second compound, but the thickness of the first electron injection layer EIL1 has a value greater than about 5 nm, and the thickness of the second electron injection layer EIL2 has a value less than about 1 nm. The thickness T1 of the first electron injection layer EIL1 and the thickness T2 of the second electron injection layer EIL2 of Comparative Example 5 each correspond to about 1 nm to about 5 nm, but the first electron injection layer EIL1 does not include the first compound or the second compound but includes zinc oxide (ZnO) that is a metal oxide.

### 2. Evaluation of light emitting elements

The evaluation results of the efficiency and element lifetime of each of the light emitting elements of Examples 1 to 8 and Comparative Examples 1 to 5 are shown in Table 2. In Table 2, the evaluation results of each of the light emitting elements of Examples 1 to 8, and Comparative Examples 1 to 5 are shown. The properties of each of the light emitting elements manufactured in Examples 1 to 8, and Comparative Examples 1 to 5 were calculated as relative efficiency, relative driving voltages and relative lifetime based on the light emitting element of Comparative Example 1, and shown in Table 2. Meanwhile, the element efficiency of the light emitting element was obtained by measuring a driving voltage (V) and emission efficiency (Cd/A) at about 10 mA/cm², and the element lifetime of the light emitting element was obtained by measuring the time consumed for attaining about 90% luminance in contrast to an initial luminance.

**Table 2**

| | Efficiency (%) | Lifetime (%) | Driving voltage (%) |
|---|---|---|---|
| Example 1 | 120 | 120 | 100 |
| Example 2 | 117 | 120 | 100 |
| Example 3 | 115 | 120 | 101 |
| Example 4 | 112 | 110 | 100 |
| Example 5 | 110 | 115 | 102 |
| Example 6 | 115 | 110 | 100 |
| Example 7 | 115 | 110 | 101 |
| Example 8 | 111 | 114 | 102 |
| Comparative Example 1 | 100 | 100 | 100 |
| Comparative Example 2 | 80 | 90 | 105 |
| Comparative Example 3 | 90 | 80 | 103 |
| Comparative Example 4 | 70 | 70 | 110 |
| Comparative Example 5 | 80 | 80 | 110 |

Referring to the results of Table 2, it can be confirmed that the emission efficiency and life-characteristics of each of Example 1 to Example 8 were improved, and the driving voltages were maintained or reduced when compared to Comparative Example 1 to Comparative Example 5. When compared to Comparative Example 1 to Comparative Example 5, in Example 1 to Example 8, it is considered that the first electron injection layer EIL1 is included, and the thickness T1 of the first electron injection layer EIL1 and the thickness T2 of the second electron injection layer EIL2 each correspond to about 1 nm to about 5 nm, and light emitting elements having improved emission efficiency and life-characteristics without substantial increase of the driving voltage are provided.

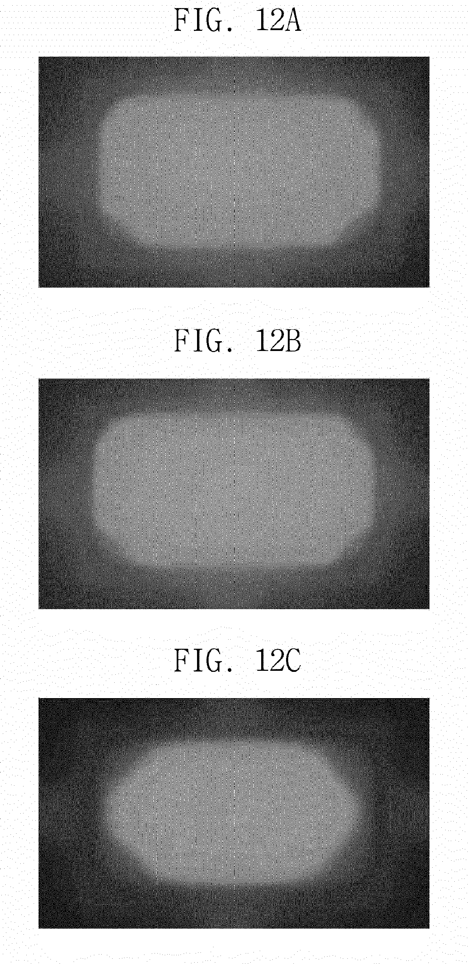

FIG. 12A and FIG. 12B are each an enlarged photographic image of a portion of the plane of (e.g., a plan view of) a luminous area of a light emitting element according to one or more embodiments, embodiments of the present disclosure, and FIG. 12C is an enlarged photographic image of a portion of the plane of (e.g., a plan view of) a luminous area of a light emitting element according to the Comparative Example. FIG. 12A to FIG. 12C are shown for particularly explaining the effects of the light emitting element according to one or more embodiments of the present disclosure. FIG. 12A to FIG. 12C show the planes of luminous areas after storing Example 1, Example 2, and Comparative Example 1 at about 85 °C for about 500 hours, respectively.

Referring to FIG. 12A to FIG. 12C, it can be confirmed that side effects of pixel shrinkage occurred in Comparative Example 1 when compared to Example 1 and Example 2. In contrast to Comparative Example 1, in Example 1 and Example 2, the first electron injection layer EIL1 is included, and the thickness T1 of the first electron injection layer EIL1 and the thickness T2 of the second electron injection layer EIL2 each correspond to about 1 nm to about 5 nm, and thus, light emitting elements in which the degree of pixel shrinkage is reduced, and emission efficiency is improved, are provided.

In the light emitting element according to one or more embodiments of the present disclosure, a first electron injection layer is disposed on an electron transport layer, and a second electron injection layer is disposed on the first electron injection layer. The first electron injection layer includes a first compound and/or a second compound, and the thickness of the first electron injection layer and the thickness of the second electron injection layer each correspond to about 1 nm to about 5 nm. Because the first electron injection layer according to one or more embodiments of the present disclosure includes the first compound and/or the second compound, a stable bonding may be formed with the second electron injection layer, and the migration and aggregation of a metal material may be prevented or reduced. Because the first electron injection layer and the second electron injection layer according to one or more embodiments of the present disclosure have the above-described thicknesses, a stable light emitting element may be achieved and obtained, and because electron transfer and injection capacity is improved, excellent or suitable emission efficiency and element lifetime may be accomplished and achieved.

The light emitting element of one or more embodiments may show improved element properties of high efficiency and long lifetime.

The display device of one or more embodiments may include the light emitting element having excellent or suitable efficiency and lifetime.

As utilized herein, the terms "substantially," "about," or similar terms are used as terms of approximation and not as terms of degree, and are intended to account for the inherent deviations in measured or calculated values that would be recognized by those of ordinary skill in the art. "About" as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein.

The light-emitting element/device, the display device, the display apparatus, or any other relevant apparatuses/devices or components according to embodiments of the present disclosure described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

Although the embodiments of the present disclosure have been described, it is understood that the present disclosure should not be limited to these embodiments, but one or more suitable changes and modifications can be made by one ordinary skilled in the art within the scope of the present disclosure as hereinafter claimed.

Accordingly, the technical scope of the present disclosure is not intended to be limited to the content set forth in the detailed description of the present disclosure, but is intended to be defined by the appended claims and equivalents thereof.

## Claims

1. A light emitting element comprising:
a first electrode;
a hole transport region on the first electrode;
an emission layer on the hole transport region;
an electron transport region on the emission layer; and
a second electrode on the electron transport region,
wherein the electron transport region comprises:
an electron transport layer on the emission layer,
a first electron injection layer on the electron transport layer, and
a second electron injection layer on the first electron injection layer,
wherein a thickness of the first electron injection layer and a thickness of the second electron injection layer each are about 1 nm to about 5 nm, and
the first electron injection layer comprises at least one of a first compound represented by Formula 1 or a second compound represented by Formula 2, and the second electron injection layer comprises a metal material: 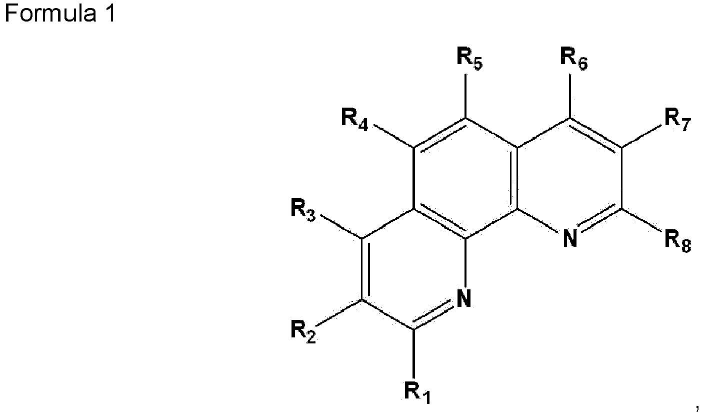
in Formula 1,
R₁ to R₈ are each independently hydrogen, deuterium, a halogen, a cyano group, a hydroxyl group, a substituted or unsubstituted oxy group, a substituted or unsubstituted thio group, a substituted or unsubstituted amine group, a substituted or unsubstituted alkyl group of 1 to 20 carbon atoms, a substituted or unsubstituted alkenyl group of 2 to 20 carbon atoms, a substituted or unsubstituted aryl group of 6 to 30 ring-forming carbon atoms, or a substituted or unsubstituted heteroaryl group of 2 to 30 ring-forming carbon atoms; and 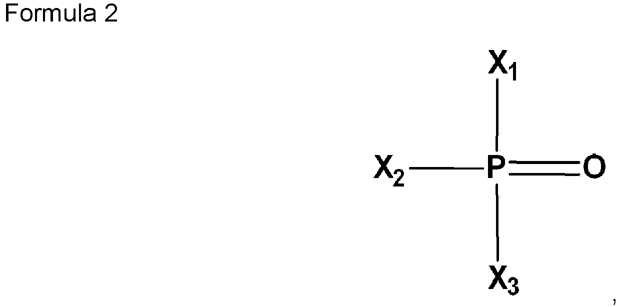 in Formula 2,
X₁ to X₃ are each independently hydrogen, deuterium, a substituted or unsubstituted alkyl group of 1 to 20 carbon atoms, a substituted or unsubstituted alkenyl group of 2 to 20 carbon atoms, a substituted or unsubstituted aryl group of 6 to 30 ring-forming carbon atoms, or a substituted or unsubstituted heteroaryl group of 2 to 30 ring-forming carbon atoms, and/or combined with an adjacent group to form a ring.

2. The light emitting element of claim 1, wherein the first electron injection layer does not comprise a metal material.

3. The light emitting element of claim 1 or claim 2, wherein the second electron injection layer is directly on the first electron injection layer.

4. The light emitting element of claim 3, wherein at least a portion of the metal material of the second electron injection layer makes a coordinate covalent bond with the N atom of the first compound or the O atom of the second compound.

5. The light emitting element of any one of claims 1 to 4, wherein the first electron injection layer is composed of the first compound represented by Formula 1 and/or the second compound represented by Formula 2.

6. The light emitting element of any one of claims 1 to 5, wherein an energy level of a lowest unoccupied molecular orbital of the first electron injection layer is about -1.85 eV or less, and an energy level of a highest occupied molecular orbital of the first electron injection layer is about -5.60 eV or less.

7. The light emitting element of any one of claims 1 to 6, wherein
in Formula 1,
R₁ to R₃, and R₆ to R₈ are each independently hydrogen, deuterium, a substituted or unsubstituted oxy group, a substituted or unsubstituted amine group, a substituted or unsubstituted aryl group of 6 to 30 ring-forming carbon atoms, or a substituted or unsubstituted heteroaryl group of 2 to 30 ring-forming carbon atoms.

8. The light emitting element of any one of claims 1 to 7, wherein
in Formula 2,
X₁ to X₃ are each independently a substituted or unsubstituted aryl group of 6 to 30 ring-forming carbon atoms, or a substituted or unsubstituted heteroaryl group of 2 to 30 ring-forming carbon atoms, and/or combined with an adjacent group to form a ring.

9. The light emitting element of any one of claims 1 to 8, wherein the first electron injection layer comprises at least one selected from among compounds of Compound Group 1:

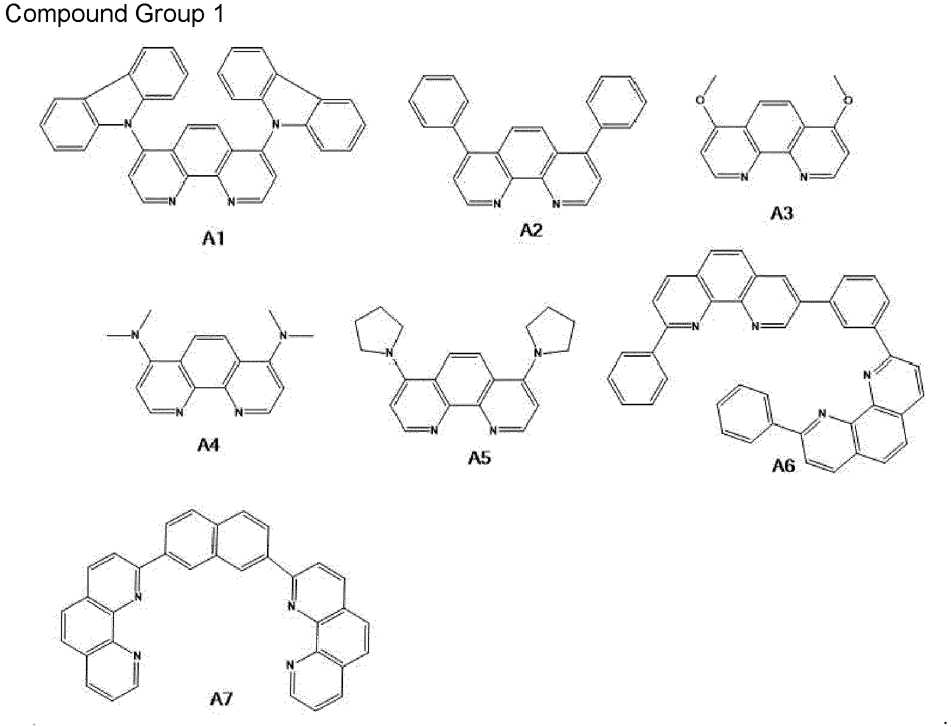

10. The light emitting element of any one of claims 1 to 9, wherein the first electron injection layer comprises at least one selected from among compounds of Compound Group 2:

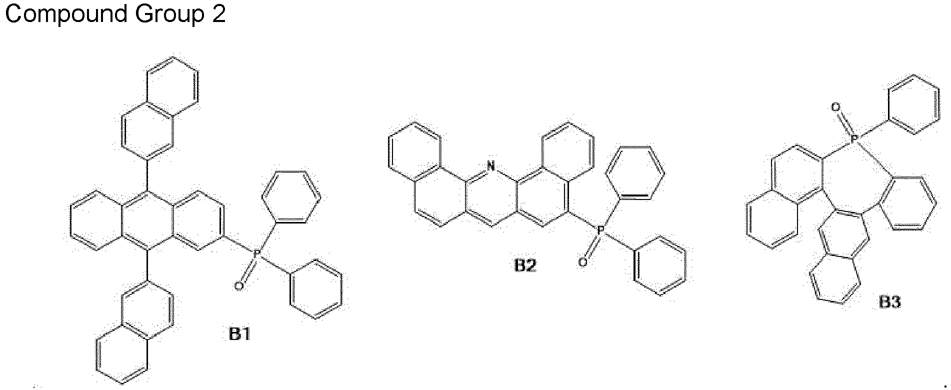

11. The light emitting element of any one of claims 1 to 10, wherein a sum of the thickness of the first electron injection layer and the thickness of the second electron injection layer is about 2 nm to about 4 nm.

12. The light emitting element of any one of claims 1 to 11, wherein a thickness percent of the first electron injection layer or a thickness percent of the second electron injection layer with respect to a thickness of the electron transport layer is from about 3% to about 7%.

13. The light emitting element of any one of claims 1 to 12, wherein the metal material in the second electron injection layer comprises a metal of lanthanoids.

14. The light emitting element of any one of claims 1 to 13, wherein the electron transport layer comprises a metal material.

15. The light emitting element of any one of claims 1 to 14, wherein:
(i) the electron transport region further comprises a hole blocking layer between the electron transport layer and the emission layer; and/or
(ii) the second electrode is directly on the second electron injection layer.
